(19) Europäisches Patentamt
European Patent Office
Office européen des brevets

(11) **EP 2 048 210 A1**

(12) **EUROPEAN PATENT APPLICATION**

(43) Date of publication:
**15.04.2009 Bulletin 2009/16**

(51) Int Cl.:
*C09J 7/02* (2006.01)　　　*C09J 7/04* (2006.01)

(21) Application number: **08017743.9**

(22) Date of filing: **09.10.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **10.10.2007 JP 2007264234**

(71) Applicant: **Nitto Denko Corporation**
**Ibaraki-shi, Osaka 567-8680 (JP)**

(72) Inventors:
　• **Daigaku, Noritsugu**
　　**Ibaraki-shi**
　　**Osaka 567-8680 (JP)**
　• **Nonaka, Takahiro**
　　**Ibaraki-shi**
　　**Osaka 567-8680 (JP)**
　• **Takahashi, Akiko**
　　**Ibaraki-shi**
　　**Osaka 567-8680 (JP)**

(74) Representative: **Grünecker, Kinkeldey,**
**Stockmair & Schwanhäusser**
**Anwaltssozietät**
**Leopoldstrasse 4**
**80802 München (DE)**

(54) **Double-sided pressure-sensitive adhesive tape or sheet for use in wiring circuit board and wiring circuit board**

(57) The present invention provides a double-sided pressure-sensitive adhesive tape or sheet for use in wiring circuit board, which includes a pressure-sensitive adhesive layer formed by a pressure-sensitive adhesive composition containing an acrylic polymer as a main component, in which the double-sided pressure-sensitive adhesive tape or sheet has an amount of total outgas of 250 μg/g or less and a diffusion amount of toluene of 10 μg/g or less. The double-sided pressure-sensitive adhesive tape or sheet has a small generating amount of VOC as well as excellent punching processing property and anti-repulsion property.

*FIG. 1*

**Description**

**FIELD OF THE INVENTION**

The present invention relates to a double-sided pressure-sensitive adhesive tape or sheet for use in wiring circuit board and a wiring circuit board.

**BACKGROUND OF THE INVENTION**

In electronic instruments, wiring circuit boards are used and, with regard to the wiring circuit board, a flexible printed circuit board (may be sometimes called "FPC") has been widely used. Usually, wiring circuit boards such as FPC are used in a state of being adhered to a reinforcing plate (such as aluminum plate, stainless steel plate or polyimide plate) and, at that time, a double-sided pressure-sensitive adhesive tape or sheet (double-sided pressure-sensitive adhesive tape or sheet for wiring circuit board) is used. With regard to such a double-sided pressure-sensitive adhesive tape or sheet, a double-sided pressure-sensitive adhesive tape or sheet having a constitution of being formed only by adhesive layers (so-called "double-sided pressure-sensitive adhesive tape or sheet without substrate") has been widely used in view of the total thickness. However, since the double-sided pressure-sensitive adhesive tape or sheet without substrate has no substrate, it is not suitable for fine perforating process. Moreover, there is a problem in the conventional double-sided pressure-sensitive adhesive tape or sheet that, especially under the conditions of high temperature and high humidity, the cut surfaces are adhered again (self-adhesion) after being perforated whereby working ability lowers. Further, in the worst case, it sometimes happens that, in detaching the perforated product, a part where a pressure-sensitive adhesive layer is deficient is resulted.

Although it has been attempted that, in the pressure-sensitive adhesive layer, matters insoluble in a solvent are increased for preventing the self-adhesion of the cut surfaces (refer to JP-A-2001-40301), there is a problem that, when the matters insoluble in a solvent are increased, the pressure-sensitive adhesive layer is peeled off from the adherend when it is adhered to a part of the adherend on which repulsive force it applied.

On the other hand, in wiring circuit board such as FPC, there are some cases where a high-temperature step such as a solder reflow step is conducted but, when the pressure-sensitive adhesive layer is adhered to a part of an adherend on which a repulsive force is applied after the solder reflow step, a problem that the pressure-sensitive adhesive layer is peeled off from the adherend arises in some cases.

Recently, particularly in pressure-sensitive adhesive tapes used for wiring circuit board for automobiles and so on, there has been demanded so-called "low VOC" property that VOC (Volatile Organic Compound) is hardly generated, from an aspect of environmental properties and safety.

**SUMMARY OF THE INVENTION**

Accordingly, an object of the present invention is to provide a double-sided pressure-sensitive adhesive tape or sheet for wiring circuit board, which has a high adhesiveness as well as has very small amounts of total outgas and toluene diffusion. Another object of the present invention is to provide a double-sided pressure-sensitive adhesive tape or sheet for wiring circuit board, which has an excellent anti-repulsion property even being subjected to a high-temperature step. Further, another object of the present invention is to provide a double-sided pressure-sensitive adhesive tape or sheet for wiring circuit board, which is able to suppress or prevent the self-adhesion of the cut sides after a cutting process and has an excellent fine processing property. Further, another object of the present invention is to provide a wiring circuit board in which the double-sided pressure-sensitive adhesive tape or sheet for wiring circuit board is used.

In order to achieve the above-mentioned objects, the present inventors have carried out intensive investigations and found that, when a pressure-sensitive adhesive layer of a double-sided pressure-sensitive adhesive tape or sheet is formed by a adhesive composition containing an acrylic polymer as a base polymer, and an amount of total outgas and a diffusion amount of toluene are adjusted to a specific amount, a good adhesiveness to the wiring circuit board and reinforcing plate can be obtained as well as excellent environmental properties and safety can be obtained, so that the double-sided pressure-sensitive adhesive tape or sheet suitably used for wiring circuit board can be obtained. Further, the present inventors have found that, when a gel fraction of the pressure-sensitive adhesive layer in the initial stage and a gel fraction after a solder reflow step under specific heat treatment conditions with respect to the gel fraction in the initial stage are adjusted to a specific range, an excellent anti-repulsion property can be achieved even being subjected to a high-temperature step by a solder reflow step and thus a good adhesiveness can be retained even when used to the part where repulsion takes place. Further, the present inventors have found that, when the tape is a double-sided pressure-sensitive adhesive tape or sheet having a substrate, in which the above-mentioned specific pressure-sensitive adhesive layer is provided on at least one surface of the substrate, the self-adhesion of the cut sides after a cutting process is suppressed or prevented and thus fine processing property is improved. The present invention has been accomplished based on these findings.

Accordingly, the present invention provides the following items 1 to 17.

1. A double-sided pressure-sensitive adhesive tape or sheet for use in wiring circuit board, which comprises a pressure-sensitive adhesive layer formed by a pressure-sensitive adhesive composition containing an acrylic polymer as a main component,

said double-sided pressure-sensitive adhesive tape or sheet having an amount of total outgas of 250 μg/g or less and a diffusion amount of toluene of 10 μg/g or less.

2. A double-sided pressure-sensitive adhesive tape or sheet for use in wiring circuit board, which comprises a substrate, a first pressure-sensitive adhesive layer provided on one surface of the substrate, and a second pressure-sensitive adhesive layer provided on the other surface of the substrate, wherein at least one of the first and second pressure-sensitive adhesive layers is formed by a pressure-sensitive adhesive composition containing an acrylic polymer as a main component,

said double-sided pressure-sensitive adhesive tape or sheet having an amount of total outgas of 250 μg/g or less and a diffusion amount of toluene of 10 μg/g or less.

3. The double-sided pressure-sensitive adhesive tape or sheet according to item 1 or 2,
wherein the pressure-sensitive adhesive layer has a gel fraction in the initial stage of 40 to 70% by weight, and a difference between a gel fraction (% by weight) after a solder reflow step and the gel fraction (% by weight) in the initial stage is 10 or less, said solder reflow step satisfying the following heat treatment conditions:

(1) a surface temperature of said pressure-sensitive adhesive tape or sheet reaches 175 ± 10°C within 130 to 180 seconds after start of the solder reflow step for said pressure-sensitive adhesive tape or sheet;
(2) the surface temperature of said pressure-sensitive adhesive tape or sheet reaches 230 ± 10°C within 200 to 250 seconds after start of the solder reflow step for said pressure-sensitive adhesive tape or sheet;
(3) the surface temperature of said pressure-sensitive adhesive tape or sheet reaches 255 ± 15°C within 260 to 300 seconds after start of the solder reflow step for said pressure-sensitive adhesive tape or sheet; and
(4) the solder reflow step finishes within 370 seconds after start of the solder reflow step for said pressure-sensitive adhesive tape or sheet.

4. The double-sided pressure-sensitive adhesive tape or sheet according to item 1 or 2, wherein the pressure-sensitive adhesive composition further contains a chain transfer substance.

5. The double-sided pressure-sensitive adhesive tape or sheet according to item 4, wherein the chain transfer substance is at least one of a compound having a hydroxyl group and a compound having a thiol group.

6. The double-sided pressure-sensitive adhesive tape or sheet according to item 4, wherein the chain transfer substance is a tackifier resin containing a phenolic hydroxyl group, or a chain transfer agent.

7. The double-sided pressure-sensitive adhesive tape or sheet according to item 6, wherein the tackifier resin containing a phenolic hydroxyl group is at least one member selected from the group consisting of a phenol-modified terpene tackifier resin, a phenol-modified rosin tackifier resin and a phenolic tackifier resin.

8. The double-sided pressure-sensitive adhesive tape or sheet according to item 6, wherein the pressure-sensitive adhesive composition contains a low-molecular weight polymer composition comprising a low-molecular weight polymer component and a chain transfer agent for adjusting the molecular weight of the low-molecular weight polymer component, whereby the chain transfer agent is contained in the pressure-sensitive adhesive composition.

9. The double-sided pressure-sensitive adhesive tape or sheet according to item 8, wherein the low-molecular weight polymer component contains, as a main monomer component, an ethylenically unsaturated monomer having a cyclic structure in the molecule thereof.

10. The double-sided pressure-sensitive adhesive tape or sheet according to item 9, wherein the low-molecular weight polymer component contains, as monomer components, 90 to 99 parts by weight of cyclohexyl methacrylate and 10 to 1 part by weight of acrylic acid.

11. The double-sided pressure-sensitive adhesive tape or sheet according to item 6, wherein the pressure-sensitive adhesive composition contains, as the chain transfer substance, the tackifier resin containing a phenolic hydroxyl group in a proportion of 5 to 45 parts by weight with respect to 100 parts by weight of the acrylic polymer.

12. The double-sided pressure-sensitive adhesive tape or sheet according to item 8, wherein the pressure-sensitive adhesive composition contains the low-molecular weight polymer composition containing the chain transfer agent as the chain transfer substance so that the low-molecular weight polymer component is contained in a proportion of 5 to 45 parts by weight with respect to 100 parts by weight of the acrylic polymer.

13. The double-sided pressure-sensitive adhesive tape or sheet according to item 2, wherein the substrate comprises nonwoven fabric.

14. The double-sided pressure-sensitive adhesive tape or sheet according to item 1, wherein the pressure-sensitive adhesive layer has a thickness of 5 to 70 $\mu$m.

15. The double-sided pressure-sensitive adhesive tape or sheet according to item 2, wherein the first and second pressure-sensitive adhesive layers each have a thickness of 5 to 70 $\mu$m.

16. The double-sided pressure-sensitive adhesive tape or sheet according to item 1 or 2, which has a thickness from one pressure-sensitive adhesive surface to the other pressure-sensitive adhesive surface of 20 to 70 $\mu$m.

17. A wiring circuit board comprising an electric insulator layer and an electric conductor layer provided on the electric insulator layer so as to form a predetermine circuit pattern, wherein the double-sided pressure-sensitive adhesive tape or sheet according to item 1 or 2 is adhered on the back side of the wiring circuit board.

Since the double-sided pressure-sensitive adhesive tape or sheet for wiring circuit board according to the present invention has the above-mentioned constitution, it has excellent environmental properties and safety so as to be useful for wiring circuit board for automobiles and the like. Further, it has a good adhesiveness and, even after being subjected to a high-temperature step, it can exert an excellent anti-repulsion property. Further, it is possible to suppress or prevent the self-adhesion of the cut sides after a cutting process and it is also excellent in fine processing property.

## BRIEF DESCRIPTION OF THE DRAWINGS

Fig. 1 is a rough cross-sectional view which partly shows an example of the double-sided pressure-sensitive adhesive tape or sheet for wiring circuit board according to the present invention.

Fig. 2 is a graph which shows an example of temperature profile of heating treatment condition in a solder reflow step.

Fig. 3 is a rough cross-sectional view which shows the adhered state of the double-sided pressure-sensitive adhesive tape or sheet for evaluation of anti-repulsive force in a method for evaluation of anti-repulsion property.

Description of Reference Numerals and Signs

1: double-sided pressure-sensitive adhesive tape or sheet for wiring circuit board

2: substrate

3: pressure-sensitive adhesive layer

4: pressure-sensitive adhesive layer

5: release liner

5a: base material for the release liner 5

5b: release treating agent layer

5c: release treating agent layer

6: double-sided pressure-sensitive adhesive tape or sheet

7: lining material (the model FPC having the characteristics as shown in Table 2)

8: adherend (a layered plate of a polyimide plate with an aluminum plate)

8a: surface of a polyimide plate

8b: surface of an aluminum plate

A: area where floating is observed

## DETAILED DESCRIPTION OF THE INVENTION

Hereinafter, embodiments of the present invention will be illustrated in more detail by referring to the drawings according to the necessity. Incidentally, the same material, site, etc. may be assigned with the same reference symbols.

The double-sided pressure-sensitive adhesive tape or sheet for wiring circuit board of the present invention at least has a pressure-sensitive adhesive layer which is formed by a pressure-sensitive adhesive composition containing an acrylic polymer as a main component. The pressure-sensitive adhesive composition may be a solvent-type acrylic pressure-sensitive adhesive composition using an organic solvent as a solvent, or may be an aqueous-dispersion type acrylic pressure-sensitive adhesive composition using an aqueous-dispersion type acrylic polymer. The pressure-sensitive adhesive composition preferably contains a chain transfer substance in addition to the acrylic polymer.

Since the pressure-sensitive adhesive layer of the double-sided pressure-sensitive adhesive tape or sheet for wiring circuit board according to the present invention is formed by a pressure-sensitive adhesive composition containing an acrylic polymer as a main component, it has a good adhesiveness. In addition, in the case that the pressure-sensitive adhesive composition contains a chain transfer substance, even when a radical component is generated in the pressure-sensitive adhesive layer by being subjected to a high-temperature step and so on, the chain transfer substance captures the radical component so that the radical component can be effectively inactivated. Therefore, a rise in gel fraction in the pressure-sensitive adhesive layer can be effectively suppressed or prevented.

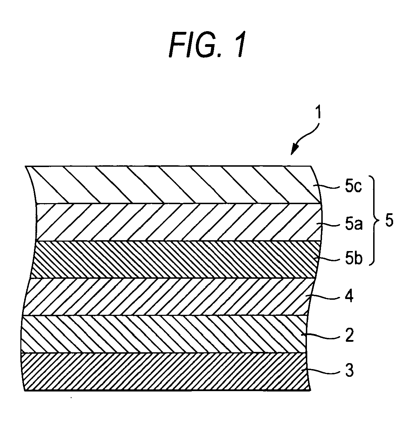

Fig. 1 is a rough cross-sectional view which partly shows an example of the double-sided pressure-sensitive adhesive tape or sheet for wiring circuit board in accordance with the present invention. In Fig. 1, 1 is a double-sided pressure-sensitive adhesive tape or sheet for wiring circuit board, 2 is a substrate, 3 is a pressure-sensitive adhesive layer, 4 is another pressure-sensitive adhesive layer, 5 is a release liner, 5a is a base material for the release liner 5,5b is a release treating agent layer and 5c is another release treating agent layer. Both of the pressure-sensitive adhesive layers 3 and 4 are formed by a pressure-sensitive adhesive composition containing an acrylic polymer as a main component.

In the double-sided pressure-sensitive adhesive tape or sheet 1 for wiring circuit board shown in Fig. 1, the pressure-sensitive adhesive layers 3 and 4 are formed on respective sides of the substrate 2, and the surfaces of the pressure-sensitive adhesive layers 3 and 4 are protected by a release liner 5 in a form of being wounded into a roll.

The double-sided pressure-sensitive adhesive tape or sheet for wiring circuit board according to the present invention preferably has characteristics that a gel fraction in the initial stage is 40 to 70% by weight, and a difference between a gel fraction (% by weight) after a solder reflow step under the following heat treatment conditions (may be referred to as "gel fraction after the reflow step") and the gel fraction (% by weight) in the initial stage is 10 or less.

(Heat treatment conditions in a solder reflow step)

(1) The surface temperature of the double-sided pressure-sensitive adhesive tape or sheet for wiring circuit board (or the pressure-sensitive adhesive layer) reaches 175 $\pm$ 10°C (165 to 185°C) within 130 to 180 seconds after start of the solder reflow step for the double-sided pressure-sensitive adhesive tape or sheet.

(2) The surface temperature of the double-sided pressure-sensitive adhesive tape or sheet for wiring circuit board (or the pressure-sensitive adhesive layer) reaches 230 $\pm$ 10°C (220 to 240°C) within 200 to 250 seconds after start of the solder reflow step for the double-sided pressure-sensitive adhesive tape or sheet.

(3) The surface temperature of the double-sided pressure-sensitive adhesive tape or sheet for wiring circuit board (or the pressure-sensitive adhesive layer) reaches 255 $\pm$ 15°C (240 to 270°C) within 260 to 300 seconds after start of the solder reflow step for the double-sided pressure-sensitive adhesive tape or sheet.

(4) The solder reflow step finishes within 370 seconds after start of the solder reflow step for the double-sided pressure-sensitive adhesive tape or sheet.

In the pressure-sensitive adhesive layer, when the gel fraction in the initial stage is from 40 to 70% by weight and the difference between the gel fraction (% by weight) after the reflow step and the gel fraction (% by weight) in the initial stage is 10 or less {that is, the gel fraction (% by weight) after the reflow step is [gel fraction (% by weight) in the initial stage + 10] or less}, a good gel fraction is retained and thus an excellent anti-repulsion property can be effectively exerted even after a high-temperature step such as a solder reflow step.

In the present invention, the gel fraction (a proportion of the matter which is insoluble in a solvent) of the pressure-sensitive adhesive layer in the initial stage is preferably 50 to 65% by weight and, particularly preferably, 55 to 65% by weight. When the gel fraction of the pressure-sensitive adhesive layer in the initial stage is less than 40% by weight, a retaining characteristic of the pressure-sensitive adhesive layer tends to be low, while, when it is more than 70% by weight, a repulsive characteristic of the pressure-sensitive adhesive layer tends to be low. Incidentally, the gel fraction of the pressure-sensitive adhesive layer in the initial stage means a gel fraction of the pressure-sensitive adhesive layer in the double-sided pressure-sensitive adhesive tape or sheet (the double-sided pressure-sensitive adhesive tape or sheet for wiring circuit board) when used for a wiring circuit board, and usually, it may be a gel fraction before a solder reflow step satisfying the above-mentioned heat treatment conditions (a gel fraction before being subjected to a solder reflow step satisfying the above-mentioned heat treatment conditions).

In the present invention, the difference (sometimes called "gel fraction Difference") between the gel fraction (% by weight) after a reflow step and the gel fraction (% by weight) in the initial stage is preferably 7 or less, more preferably 5 or less, still more preferably 3 or less (particularly, 1 or less) and, particularly preferably, 0. Needless to say, the lower limit of the gel fraction difference is usually 0 (that is, the gel fraction (% by weight) after the reflow step and the gel fraction (% by weight) in the initial stage are the same value).

In the present invention, the gel fraction is a value calculated by the "Method for measurement of gel fraction" mentioned below.

(Method for measurement of gel fraction)

After a pressure-sensitive adhesive composition is applied on a release liner, it is dried or hardened to form a pressure-sensitive adhesive layer. About 0.1 g of the pressure-sensitive adhesive layer or the pressure-sensitive adhesive layer after a solder reflow step satisfying the above-mentioned heat treatment conditions is wrapped with a porous tetrafluoroethylene sheet containing pores having an average pore diameter of 0.2 $\mu$m (trade name: "NTF 1122"; manufactured by Nitto Denko Corporation) and tied up with a kite string and the weight at that time is measured and used as a weight before dipping. Incidentally, the weight before dipping is a total weight of the pressure-sensitive adhesive layer, the tetrafluoroethylene sheet and the kite string. Further, the total weight of the tetrafluoroethylene sheet and the kite string is also measured and the weight is defined as a package weight.

After that, the product where the pressure-sensitive adhesive layer is wrapped with the tetrafluoroethylene sheet followed by being tied up with the kite string is placed in a 50-ml container filled with ethyl acetate and allowed to stand at room temperature for one week (7 days). Then, the tetrafluoroethylene sheet is taken out from the container, transferred to a cup made of aluminum and dried in a drier at 130°C for 2 hours to remove ethyl acetate, then the weight of the sample is measured and the weight is defined as a weight after dipping.

Now a gel fraction is calculated by the following formula:

$$\text{Gel fraction (\% by weight)} = (A - B)/(C - B) \times 100 \quad (1)$$

(In the formula (1), A is weight after dipping, B is package weight and C is weight before dipping.).

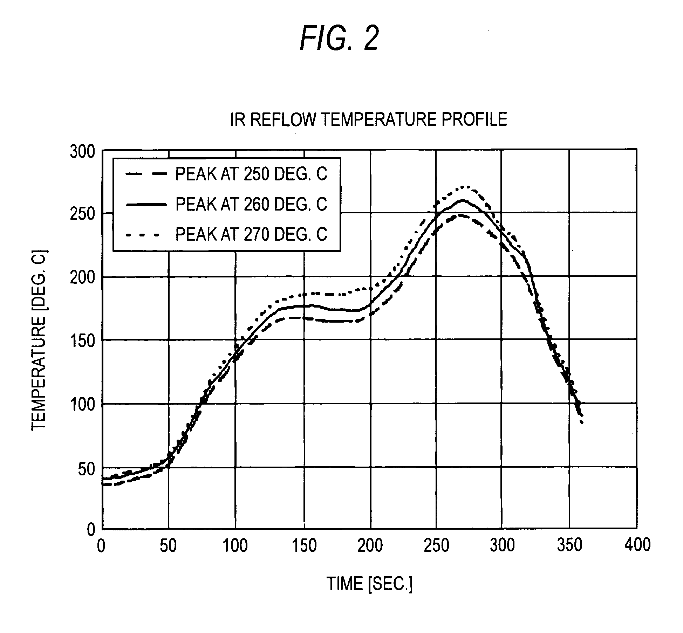

With regard to a solder reflow step satisfying the above-mentioned heat treatment conditions in the present invention, there is no particular limitation so long as it is a solder reflow step satisfying the above-mentioned heat treatment conditions and an example thereof is a solder reflow step satisfying the heat treatment conditions with a temperature profile shown by the graph in Fig. 2. In Fig. 2, an ordinate is temperature (°C, degree Celsius) and an abscissa is time (second (sec.)). In Fig. 2, temperature profiles of three examples where the peak temperature or the highest temperature is about 250°C, about 260°C and about 270°C are shown. In the present invention, the surface temperature of the double-sided pressure-sensitive adhesive tape or sheet (or the pressure-sensitive adhesive layer) in the solder reflow step is continuously measured by a temperature sensor after a thermocouple is fixed on the surface of the double-sided pressure-sensitive adhesive tape or sheet (or adhesive layer) using a pressure-sensitive adhesive tape (a heat-resistant pressure-sensitive adhesive tape including a polyimide film as a substrate). Incidentally, in the solder reflow step, the following solder reflow instrument is used and, in the measurement of the surface temperature, the following temperature sensor is used:

Solder reflow instrument: Conveyer-type heating apparatus by far-infrared and hot wind heating device (manufactured by Noritake Co., Ltd.)

Temperature sensor: Keyence NR-250 (manufactured by Keyence Corporation). In the double-sided pressure-sensitive adhesive tape or sheet for wiring circuit board according to the present invention, a diffusion amount of toluene is 10 $\mu$g/g or less, preferably 5 $\mu$g/g or less, and more preferably 3 $\mu$g/g or less. The "diffusion amount of toluene" used herein indicates an amount ($\mu$g/g) of generated toluene per unit weight of a test sample (the double-sided pressure-sensitive adhesive tape or sheet for wiring circuit board) which is measured according to a method as described below.

In the double-sided pressure-sensitive adhesive tape or sheet for wiring circuit board according to the present invention, an amount of total outgas is 250 $\mu$g/g or less, preferably 200 $\mu$g/g or less, and more preferably 150 $\mu$g/g or less. The "amount of total outgas" used herein indicates an amount ($\mu$g/g) of generated gas per a unit weight of a sample (the double-sided pressure-sensitive adhesive tape or sheet for wiring circuit board) which is measured according to a method as described below.

When the diffusion amount of toluene is more than 10 $\mu$g/g or the amount of total outgas is more than 250 $\mu$g/g, it is not preferable from an environmental aspect, and it is not preferable also from an aspect of safety to a human body in a case of the use for automobiles and the like.

Acrylic polymer

As an acrylic polymer which is a main component in a pressure-sensitive adhesive composition for the formation of a pressure-sensitive adhesive layer, it is possible to use polymer of a (meth) acrylate type containing a (meth) acrylate (acrylate or methacrylate) as a main monomer component Examples of such a (meth)acrylate include the alkyl (meth) acrylate as shown below, as well as cycloalkyl (meth)acrylate such as cyclohexyl (meth)acrylate and aryl (meth)acrylate such as phenyl (meth)acrylate. As the (math)acrylate, an alkyl (meth)acrylate may be used advantageously. That is, as an acrylic polymer, polymer of a (meth)acrylate type containing an alkyl (meth)acrylate as a main monomer component may be advantageously used. The (meth)acrylate may be used solely or two or more thereof may be used in combination.

Examples of the alkyl (meth)acrylate used as a main monomer component in the acrylic polymer include methyl (meth)acrylate, ethyl (meth)acrylate, propyl (meth)acrylate, isopropyl (meth)acrylate, n-butyl (meth)acrylate, isobutyl (meth)acrylate, sec-butyl (meth)acrylate, tert-butyl (meth)acrylate, pentyl (meth)acrylate, isopentyl (meth)acrylate, neopentyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth) acrylate, hexadecyl (meth)acrylate, heptadecyl (meth)acrylate, octadecyl (meth)acrylate, nonadecyl (meth)acrylate and eicosyl (meth)acrylate.

With regard to the (meth)acrylate such as an alkyl (meth)acrylate in the acrylic polymer, since it is used as a main monomer component, it is important that the proportion thereof with respect to the total amount of monomer components is 50% by weight or more, preferably 80% by weight or more and, more preferably, 90% by weight or more. Although the upper limit of the (meth)acrylate with respect to the total amount of the monomer components is not particularly limited, it is preferably 99% by weight or less (preferably 98% by weight or less and, more preferably, 97% by weight or less). When the proportion of the (meth)acrylate with respect to the total amount of the monomer components is less than 50% by weight, there are some cases where characteristics as an acrylic polymer (such as adhesiveness) are hardly exerted.

In the acrylic polymer, it is possible that a monomer component which is capable of being copolymerized with the (meth)acrylate (copolymerizing monomer) is used as a monomer component The copolymerizing monomer may be used for introduction of a cross-linking point into the acrylic polymer or for control of cohesive force of the acrylic polymer. Each copolymerizing monomer may be used solely or two or more thereof may be used in combination.

To be more specific, as the copolymerizing monomer, it is possible to use a monomer component containing a functional monomer (particularly, a monomer component containing a thermal cross-linking functional group for introduction of cross-linking point which can be subjected to a thermal cross-linking to an acrylic polymer) for introduction of a cross-linking point into an acrylic polymer. With regard to such a monomer containing a functional group, there is no particular limitation so long as it is a monomer component which is capable of being copolymerized with an alkyl (meth) acrylate and has a functional group which can be a cross-linking point, and examples thereof include a monomer containing a carboxyl group such as (meth)acrylic acid, itaconic acid, crotonic acid, maleic acid, fumaric acid and isocrotonic acid or an acid anhydride thereof (such as maleic anhydride and itaconic anhydride); a hydroxyalkyl (meth) acrylate such as 2-hydroxyethyl (meth)acrylate, 2-hydroxypropyl (meth)acrylate and 2-hydroxybutyl (meth)acrylate; and, in addition, a monomer containing a hydroxyl group such as vinyl alcohol and allyl alcohol; an amide-type monomer such as (meth)acrylamide, N,N-dimethyl(meth)acrylamide, N-butyl (meth)acrylamide, N-methylol (meth)acrylamide, N-methylolpropane (meth)acrylamide, N-methoxymethyl (meth)acrylamide and N-butoxymethyl (meth)acrylamide; a monomer containing an amino group such as aminoethyl (meth)acrylate, N,N-dimethylaminoethyl (meth)acrylate and tert-butylaminoethyl (meth)acrylate; a monomer containing an epoxy group such as glycidyl (meth)acrylate and methylglycidyl (meth)acrylate; a cyano-containing monomer such as acrylonitrile and methacrylonitrile; and a monomer having a nitrogen-containing ring such as N-vinyl-2-pyrrolidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam and N-(meth)acryloylmorpholine. As the monomer component containing a functional group, a monomer containing a carboxyl group such as acrylic acid or an acid anhydride thereof may be advantageously used.

As a copolymerizing monomer, it is also possible to use other copolymerizing monomer component in order to control the cohesive force of the acrylic polymer. Examples of other copolymerizing monomer component as such include a monomer of a vinyl ester type such as vinyl acetate and vinyl propionate; a monomer of a styrene type such as styrene, substituted styrene (e.g., α-methylstyrene) and vinyl toluene; a monomer of an olefin type such as ethylene, propylene, isoprene, butadiene and isobutylene; vinyl chloride and vinylidene chloride; a monomer containing an isocyanate group such as 2-(meth)acryloyloxyethyl isocyanate; a monomer containing an alkoxy group such as methoxyethyl (meth)acrylate and ethoxyethyl (meth)acrylate; a monomer of a vinyl ether type such as methyl vinyl ether and ethyl vinyl ether; and a multifunctional monomer such as 1,6-hexanediol di(meth)acrylate, ethylene glycol di(meth)acrylate, diethylene glycol di(meth)acrylate, triethylene glycol di(meth)acrylate, tetraethylene glycol di(meth)acrylate, (poly)ethylene glycol di(meth)acrylate, propylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, glycerol di(meth)acrylate, epoxyacrylate, polyester acrylate, urethane acrylate, divinylbenzene, butyl di(meth)acrylate and hexyl di(meth)acrylate.

As the copolymerizing monomer in an acrylic polymer, a monomer containing a carboxyl group is preferred and, in view of heat resistance, acrylic acid may be used particularly preferably.

In the acrylic polymer, the proportion of the copolymerizing monomer may be appropriately selected within a range of less than 50% by weight with respect to the total amount of the monomer components depending upon the type of the monomer components. For example, when the copolymerizing monomer is a monomer containing a carboxyl group (particularly, acrylic acid), it is adequate that the monomer containing a carboxylic acid (particularly, acrylic acid) is 2 to 12% by weight (preferably 3 to 10% by weight, and more preferably 4 to 10% by weight) with respect to the total monomer components.

When the acrylic polymer is an aqueous-dispersion type acrylic polymer, it is preferred to use a (meth)acryloyloxy group-containing silane compound (a silane coupling agent) as a copolymerizing monomer. By copolymerizing with such a (meth)acryloyloxy group-containing silane compound, cohesive force is improved so as to obtain the pressre-sensitive adhesive which is excellent in adhesiveness and anti-repulsion property. As the (meth)acryloyloxy group-containing silane compound which can be used as the copolymerizing monomer, there may be mentioned 3-methacryloyloxypropylmethyldimethoxysilane, 3-(meth)acryloyloxy propyltrimethoxysilane, 3-methacryloyloxy propylmethyldiethoxysilane, 3-methacryloyloxy propyltriethoxysilane and the like. A proportion of the (meth)acryloyloxy group-containing silane compound is preferably 0.005 to 0.3% by weight, and more 0.005 to 0.1 % by weight, with respect to the total weight of the monomer components.

The acrylic polymer can be prepared by a conventional or common polymerization method. Examples of the polymerization method for the acrylic polymer include a solution polymerization method, an emulsion polymerization method, a bulk polymerization method and a polymerization method by irradiation of ultraviolet ray. In the polymerization of the acrylic polymer, an appropriate component which is suitable for each polymerization method such as polymerization initiator, chain transfer agent, emulsifier and solvent may be appropriately selected from conventional or common ones and may be employed.

The polymerization initiator used in the polymerization of the acrylic polymer can be properly selected from known or conventional polymerization initiators, according to the kind of the polymerization method. As the polymerization initiator, there may be mentioned, for example, an azo-type polymerization initiator such as potassium persulfate 2,2'-azobisisobutyronitrile, 2,2'-azobis(2-methylpropionamidine) disulfate, 2,2'-azobis(2-amidinopropane)dihydrochloride, 2,2'-azobis[2-(5-methyl-2-imidazoline-2-yl)propane]dihydrochloride, 2,2'-azobis(N,N'-dnnethyleneisobutylamidine), 2,2'-azobis(4-methoxy-2,4-dimethylvaleronitrile), 2,2'-azobis(2,4-dimethylvaleronitrile), 2,2'-azobis(2-methylbutyronitrile), 1,1'-azobis(cyclohexane-1-carbonitrile), 2,2'-azobis(2,4,4-trimethylpentane), and dimethyl-2,2'-azobis(2-methylpropionate); persulfates such as potassium persulfate, and ammonium persulfate; a peroxide-type polymerization initiator such as benzoylperoxide, t-butylhydroperoxide, di-t-butylperoxide, t-butylperoxybenzoate, dicumylperoxide, 1,1-bis(t-butylperoxy)-3,3,5-trimethylcyclohexane, 1,1-bis(t-butylperoxy)cyclododecane, and hydrogen peroxide; an ethane-type polymerization initiator such as phenyl-substituted ethane; aromatic carbonyl compounds; a redox-type initiator by the combination of a peroxide with a reducing gent including the redox-type polymerization initiator such as the combination of peroxide with ascorbic acid (the combination of hydrogen peroxide with ascorbic acid, and the like), the combination of peroxide with iron (II) salt (the combination of hydrogen peroxide with iron (II) salt, and the like), and the combination of persulfate salt with sodium hydrogen sulfite. Each of those polymerization initiators may be used solely or two or more thereof may be used in combination.

An amount of the polymerization initiator to be used may be a conventionally used amount, and, for example, may be appropriately selected within a range of about 0.005 to 1 part by weight with respect to 100 parts by weight of the total monomer components.

In order to adjust the molecular weight upon the polymerization, the chain transfer agents described below may be used. Each of those chain transfer agents may be used solely or two or more thereof may be used in combination. An amount of the chain transfer agent to be used may be a conventionally used amount, and, for example, may be appropriately selected within a range of about 0.001 to 0.5 part by weight with respect to 100 parts by weight of the total monomer components.

When an aqueous-dispersion type acrylic polymer is used as the acrylic polymer, the aqueous-dispersion type acrylic polymer may be prepared using a polymerized material itself which is prepared by using an emulsion polymerization method, or may be prepared by dispersing in water an acrylic polymer which is prepared by using polymerization methods other than the emulsion polymerization method. Upon the emulsion polymerization or the dispersion of the acrylic polymer in water, an emulsifying agent may be used. The emulsifying agent may be used solely, or two or more thereof may be used in combination.

Specifically, as the emulsifying agent, it may be mentioned an emulsifying agent in any form, but, for example, anionic emulsifying agents and nonionic emulsifying agents may be suitably used. As the anionic emulsifying agent, there may be mentioned, for example, an alkylsulfate-type anionic emulsifying agent such as sodium laurylsulfate, ammonium laurylsulfate, and potassium laurylsulfate; a polyoxyethylenealkylethersulfate-type anionic emulsifying agent such as sodium polyoxyethylenelaurylethersulfate; a polyoxyethylenealkylphenylethersulfate-type anionic emulsifying agent such as ammonium polyoxyethylenelaurylphenylether sulfate, and sodium polyoxyethylenclaurylphenylether sulfate; a sulfonate-type anionic emulsifying agent such as sodium dodecylbenzenesulfonate; a sulfosuccinate-type anionic emulsifying agent such as disodium lauryl sulfosuccinate, and disodium polyoxyethylenesulfosuccinate; and the like. As the nonionic emulsifying agent, there may be mentioned, for example, a polyoxyethylenealkylether-type nonionic emulsifying agent such as polyoxyethylenelaurylether; a polyoxyethylenealkylphenylether-type nonionic emulsifying agent such as polyoxyethylenelaurylphenylether; a nonionic emulsifying agent such as polyoxyethylene fatty acid ester, and polyoxyethylenepolyoxypropylene block polymer; and the like.

An amount of the emulsifying agent to be used is not particularly limited so long as it is possible to prepare the acrylic polymer in the form of emulsion, and, for example, may be appropriately selected within a range of about 0.2 to 10% by weight (preferably 0.5 to 5% by weight) with respect to the total amount of the monomer components

In order to enhance the retaining characteristic of the pressure-sensitive adhesive layer, the acrylic polymer may have a cross-linking structure using a cross-linking agent or the above-mentioned multifunctional monomer as a copolymerizing monomer component. By adjusting the amount of the cross-linking agent or the multifunctional monomer used, a gel fraction (a proportion of a matter which is insoluble in a solvent) in the pressure-sensitive adhesive layer may be controlled.

Besides a cross-linking agent of an isocyanate type, a cross-linking agent of an epoxy type, a cross-linking agent of a melamine type and a cross-linking agent of a peroxide type, examples of the cross-linking agent which are further listed include a cross-linking agent of a urea type, a cross-linking agent of a metal alkoxide type, a cross-linking agent of a metal chelate type, a cross-linking agent of a metal salt type, a cross-linking agent of a carbodiimide type, a cross-linking agent of an oxazoline type, a cross-linking agent of an aziridine type and a cross-linking agent of an amine type and, among them, a crosslinking agent of an isocyanate type and a cross-linking agent of an epoxy type may be advantageously used. Each of those cross-linking agents may be used solely or two or more thereof may be used in combination.

In the cross-linking agent, examples of the cross-linking agent of an isocyanate type include lower aliphatic polyisocyanates such as 1,2-ethylene diisocyanate, 1,4-butylene diisocyanate and 1,6-hexamethylene diisocyanate; alicyclic polyisocynates such as cyclopentylene diisocyanate, cyclohexylene diisocyanate, isophorone diisocyanate, hydrogenated tolylene diisocyanate and hydrogenated xylene diisocyanate; and aromatic polyisocyanates such as 2,4-tolylene diisocyanate, 2,6-tolylene diisocyanate, 4,4'-diphenylmethane diisocyanate and xylylene diisocyanate. Besides them, it is also possible to use an adduct of trimethylolpropane/tolylene diisocyanate trimer (manufactured by Nippon Polyurethane Industry Co., Ltd.; trade name: "Coronate L"), an adduct of trimethylolpropane/hexamethylene diisocyanate trimer (manufactured by Nippon Polyurethane Industry Co., Ltd.; trade name: "Coronate HL"), and the like.

Examples of the cross-linking agent of an epoxy type include N,N,N',N'-tetraglycidyl m-xylenediamine, diglycidyl aniline, 1,3-bis(N,N-glycidylaminomethyl)-cyclohexane, 1,6-hexanediol diglycidyl ether, neopentyl glycol diglycidyl ether, ethylene glycol diglycidyl ether, propylene glycol diglycidyl ether, polyethylene glycol diglycidyl ether, polypropylene glycol diglycidyl ether, sorbitol polyglycidyl ether, glycerol polyglycidyl ether, pentaerythritol polyglycidyl ether, polyglycerol polyglycidyl ether, sorbitan polyglycidyl ether, trimethylolpropane polyglycidyl ether, adipic acid diglycidyl ester, o-phthalic acid diglycidyl ester, triglycidyl-tris(2-hydroxyethyl) isocyanurate, resorcinol diglycydl ether and bisphenol S-diglycidyl ether and, besides them, resins of an epoxy type having two or more epoxy groups in the molecule thereof may also be mentioned.

In the case of the cross-linking agent of an epoxy type, a proportion of thereof is preferably from 0.01 to 0.2 parts by weight, and more preferably from 0.02 to 0.1 parts by weight, converted as solid, with respect to 100 parts by weight of the acrylic polymer. In the case of the cross-linking agent of an isocyanate type, a proportion thereof is preferably from 0.1 to 2 parts by weight, and more preferably from 0.2 to 1 part by weight, converted as solid with respect to 100 parts by weight of the acrylic polymer. When the proportion is below the above ranges, processing property of the pressure-sensitive adhesive layer is deteriorated in some cases, while when it exceeds the above ranges, repulsion property is deteriorated in some cases.

In the present invention, instead of or in addition to the use of a cross-linking agent, it is also possible to form a pressure-sensitive adhesive layer by subjecting to a cross-linking treatment by means of irradiation of electronic ray, ultraviolet ray, and the like.

A content of the acrylic polymer in the pressure-sensitive adhesive composition is preferably 68 to 95 parts by weight, and more preferably 71 to 83 parts by weight, converted as solid, with respect to 100 parts by weight of total solid of the pressure-sensitive adhesive composition. Incidentally, the acrylic polymer in the present invention refers to what does not contain a cross-linking agent

Weight-average molecular weight of the acrylic polymer may be appropriately selected from the range of, for example, 700,000 to 2,000,000 (preferably 800,000 to 1,700,000 and, more preferably, 900,000 to 1,400,000). When the weight-average molecular weight of the acrylic polymer is less than 700,000, there may be the case where no good adhesive characteristic is achieved while, when it is more than 2,000,000, there may be the case where problem is resulted in an applying property, whereby both of them are not preferred.

The weight-average molecular weight of the acrylic polymer can be controlled by the type and the use amount of polymerization initiator and chain transfer agent, by temperature and time for the polymerization and further by concentration of the monomer, dropping speed of the monomer, and the like. Incidentally, in the present invention, the weight-average molecular weight of the acrylic polymer was measured under the same conditions as in the case of the low-molecular weight polymer component.

Chain transfer substance

In the double-sided pressure-sensitive adhesive tape or sheet for wiring circuit board of the present invention, the pressure-sensitive adhesive composition for forming the pressure-sensitive adhesive layer preferably contains a chain transfer substance. As the chain transfer substance, it is possible to use a substance (a compound) which is able to achieve a chain transfer property capable of capturing a radical to subject it to chain transfer, and examples thereof include a compound containing a hydroxyl group and a compound containing a thiol group (a mercapto group). The chain transfer substance may be used solely or two or more thereof may be used in combination. The hydroxyl group may be a hydroxyl group which is directly bonded to carbon atom constituting a chain such as that in an alkyl group or to a carbon atom constituting a non-aromatic ring such as that in a cycloalkyl group or may be a hydroxyl group (a phenolic hydroxyl group) which is directly bonded to a carbon atom constituting an aromatic ring such as that in an aryl group. Like the hydroxyl group, the thiol group may be a thiol group which is directly bonded to carbon atom constituting a chain such as that in an alkyl group or to a carbon atom constituting a non-aromatic ring such as that in a cycloalkyl group or may be a thiol group (a thiophenolic thiol group) which is directly bonded to a carbon atom constituting an aromatic ring such as that in an aryl group.

As the chain transfer substance used in the present invention, a tackifier resin (tackifier) having a chain transfer property or a chain transfer agent may be advantageously used.

(Tackifier resin having a chain transfer property)

As mentioned above, it is possible in the present invention to use a tackifier resin having a chain transfer property (it may be sometimes called "tackifier resin having chain transfer property") as a chain transfer substance. Accordingly, a tackifier resin used for imparting an adhesiveness to a pressure-sensitive adhesive layer or a pressure-sensitive adhesive composition may be used as a chain transfer substance for imparting a chain transfer property to the pressure-sensitive adhesive layer or the pressure-sensitive adhesive composition. When a tackifier resin having chain transfer property is used as a chain transfer substance, a chain transfer property can be imparted to a pressure-sensitive adhesive composition or a pressure-sensitive adhesive layer together with an adhesiveness. Accordingly, it is not necessary to separately use a chain transfer substance with an object of only imparting a chain transfer property to a pressure-sensitive adhesive layer or a pressure-sensitive adhesive composition, whereby there is no risk of giving a bad affection to characteristics of the pressure-sensitive adhesive layer or the pressure-sensitive adhesive composition.

Further, when a tackifier resin is used as a chain transfer substance, since a tackifier resin is contained in a pressure-sensitive adhesive layer, it is possible to improve the adhesiveness and, therefore, the pressure-sensitive adhesive layer can exert an excellent anti-repulsion property due to the above viewpoint as well.

As a tackifier resin having chain transfer property, it is possible to use a tackifier resin having a hydroxyl group and, particularly, a tackifier resin containing a phenolic hydroxyl group (an aromatic ring containing a hydroxyl group) may be advantageously used (it may be sometime called "phenolic hydroxyl group-containing tackifier resin"). As the phenolic hydroxyl group-containing tackifier resin, a phenol-modified terpene tackifier resin (tackifier resin of terpene phenol type), a phenol-modified rosin tackifier resin (tackifier resin of rosin phenol type) and a phenolic tackifier resin are preferable. The tackifier resin having chain transfer property may be used solely or two or more thereof may be used in combination.

In the tackifier resin containing a phenolic hydroxyl group, examples of the phenol-modified terpene tackifier resin include phenol-modified terpene resins (terpene phenol resins) where various kinds of terpene resins (such as an α-pinene polymer, a β-pinene polymer and a dipentene polymer) are modified with phenol.

Examples of the phenol-modified rosin tackifier resin include phenols-modified rosin resins (rosin-modified phenol resins) where phenol is added to various kinds of rosins (such as non-modified rosin, modified rosin and various kinds of rosin derivatives) using an acid catalyst followed by subjecting it to a thermal polymerisation so that said various kinds of rosins are subjected to modification with phenol.

Further, examples of the phenolic tackifier resin include condensates of various kinds of phenols such as phenol, resorcinol, cresols (including m-cresol and p-cresol), xylenols (including 3,5-xylenol) and alkylphenols including p-isopropylphenol, p-tertbutylphenol, p-amylphenol, p-octylphenol, p-nonylphenol and p-dodecylphenol (particularly, p-alkylphenols) with formaldehyde (such as alkylphenol resin, phenol formaldehyde resin and xylene formaldehyde resin) as well as resol where the above-mentioned phenols are subjected to an addition polymerization with formaldehyde using an alkali catalyst, and novolak where the above-mentioned phenols are subjected to a condensation reaction with formaldehyde using an acid catalyst. Although the number of carbon atom(s) of the alkyl group in the alkylphenols is not particularly limited, it may be appropriately selected from the range of 1 to 18. Preferred examples of the phenolic tackifier resin include alkylphenol resin and xylene formaldehyde resin and, among them, alkylphenol resin is particularly preferred.

With regard to a tackifier resin having chain transfer property such as a phenolic hydroxyl group-containing tackifier resin, it is advantageous to use a phenolic hydroxyl group-containing tackifier resin having a softening point of not lower than 80°C (particularly, not lower than 100°C) in view of heat resistance, etc.

Although there is no particular limitation for the amount of the tackifier resin having chain transfer property, it may be, for example, preferably from the range of from 5 to 45 parts by weight, more preferably 10 to 40 parts by weight, and even more preferably 20 to 40 parts by weight, converted as solid, with respect to 100 parts by weight of the acrylic polymer in the pressure-sensitive adhesive composition. When the amount of the chain transfer tackifier resin is less than 5 parts by weight, a preventive effect for a rise of insoluble matters in a solvent after a solder reflow step lowers while, when it is more than 45 parts by weight, tackiness of the pressure-sensitive adhesive composition lowers to lower adhesiveness or tackiness.

When the pressure-sensitive adhesive composition is an aqueous-dispersion type acrylic adhesive composition, the tackifier resin having chain transfer property may be added to the pressure-sensitive adhesive composition as a tackifier resin-containing emulsion in which the tackifier resin is dispersed in water. In this case, the tackifier resin-containing emulsion may be generally prepared by dissolving or melting the tackifier resin and then dispersing in water. As a method of dissolving or melting the tackifier resin, there may be used a method of melting the tackifier resin by heating (when a softening-point of the tackifier resin is low), a method of melting the tackifier resin under high pressure and high temperature substantially without using an organic solvent, a method of melting the tackifier resin using a material other than an aromatic hydrocarbon-type organic solvent (when a softening-point of the tackifier resin is high), and the like.

As the method of melting the tackifier resin substantially without using an organic solvent, a non-solvent system high-pressure emulsifying method, a non-solvent system phase inversion emulsifying method and the like may be mentioned. The non-solvent system high-pressure emulsifying method includes heating the tackifier resin to its softening-point or higher, premixing it as the molten state with water and an appropriate emulsifying agent to be emulsified with a high-pressure emulsifying apparatus. In addition, the non-solvent system phase inversion emulsifying method includes heating the tackifier resin under atmospheric or higher pressure to its softening-point or higher, pouring an emulsifying agent thereto, slowly adding hot water thereto to be subjected to phase-inversion emulsification.

In the method of melting the tackifier resin using a material other than an aromatic hydrocarbon-type organic solvent, as the material other than an aromatic hydrocarbon-type organic solvent, it may be suitably selected according to the kind of the tackifier resin, and an alicyclic hydrocarbon-type organic solvent may be suitably used. As such an alicyclic hydrocarbon-type organic solvent, there may be mentioned, for example, cyclohexanes (cyclohexane, alkyl group-containing cyclohexane such as methylcyclohexane, ethylcyclohexane, dimethylcyclohexane, and methylethylcyclohexane, and the like), as well as cyclopentanes (cyclopentane, alkyl group-containing cyclopentane, and the like), cycloheptanes (cycloheptane, alkyl group-containing cycloheptane, and the like), cyclooctanes (cyclooctane, alkyl group-containing cyclooctane, and the like) and the like, which correspond to the cyclohexanes. Herein, each of the organic solvents such as the alicyclic hydrocarbon-type organic solvent may be used solely or two or more thereof may be used in combination.

An amount of the organic solvents to be used such as the alicyclic hydrocarbon-type organic solvent is not particularly limited, and may be a proportion in which it is possible to dissolve or melt the tackifier resin and then optionally dispersed in water using an emulsifying agent but it is preferred to use a minimum amount thereof as possible. It is important to remove the organic solvent by a known or conventional method (for example, a method of evaporation-off under reduced pressure, and the like) as possible after preparing the tackifier resin-containing emulsion.

(Chain transfer agent)

In the present invention, it is also possible to use a chain transfer agent as mentioned above, as the chain transfer substance. With regard to the chain transfer agent, although it is possible to introduce a chain transfer agent into a pressure-sensitive adhesive composition by addition of the chain transfer agent to the pressure-sensitive adhesive composition, it is preferred to introduce a chain transfer agent into a pressure-sensitive adhesive composition by such a means that a low-molecular weight polymer composition containing a low-molecular weight polymer component (a polymer component having a low molecular weight) and a chain transfer agent for adjusting the molecular weight of the low-molecular weight polymer component is added to the pressure-sensitive adhesive composition. Accordingly, a chain transfer agent used for preparing a low-molecular weight polymer component (in other words, a chain transfer agent in a low-molecular weight polymer composition containing a low-molecular weight polymer component and a chain transfer agent for adjusting the molecular weight of the low-molecular weight polymer component) may be used as a chain transfer substance for imparting a chain transfer property to a pressure-sensitive adhesive layer or a pressure-sensitive adhesive composition. When the low-molecular weight polymer composition containing a chain transfer agent is used as a chain transfer substance, it is now possible to impart a chain transfer property together with the characteristic of the low-molecular weight polymer component. Accordingly, it is not necessary to separately use a chain transfer substance with an object of only imparting a chain transfer property to a pressure-sensitive adhesive layer or a pressure-sensitive adhesive composition, whereby there is no risk of giving a bad affection to characteristics of the pressure-sensitive adhesive layer or the pressure-sensitive adhesive composition.

Further, when a chain transfer agent for preparing a low-molecular weight polymer component is used as a chain transfer substance, since a low-molecular weight polymer component is contained in a pressure-sensitive adhesive layer, it is possible to improve the adhesiveness and, therefore, the pressure-sensitive adhesive layer can exert an excellent anti-repulsion property due to the above viewpoint as well.

The chain transfer agent may be used by appropriately selecting from the conventional chain transfer agents, and a chain transfer agent having a hydroxyl group (it will be sometimes called "hydroxyl group-containing chain transfer agent") and a chain transfer agent having a thiol group (it will be sometimes called "thiol group-containing chain transfer agent") may be appropriately used. Specific examples of the chain transfer agent include a hydroxyl group-containing chain transfer agent such as benzyl alcohol, α-methylbenzyl alcohol and hydroquinone; and a thiol group-containing chain transfer agent such as alkyl mercaptane (including octyl mercaptan, lauryl mercaptan and stearyl mercaptan), benzyl mercaptan, glycidyl mercaptan, thioglycolic acid (mercaptoacetic acid), 2-ethylhexyl thioglycolate, octyl thioglycolate, methoxybutyl thioglycolate, 3-mercaptopropionic acid, octyl mercaptopropionate, methoxybutyl mercaptopropionate, 2-mercaptoethanol, 3-mercapto-1,2-propanediol, 2,3-dimercapto-1-propanol and thioglycerol.

It is also possible to use a chain transfer agent having no hydroxyl group or thiol group (such as an α-methylstyrene dimer) as a chain transfer agent. A chain transfer may be used solely or two or more thereof may be used in combination.

When a chain transfer agent for adjustment of molecular weight of a low-molecular weight polymer in a low-molecular weight polymer composition is used as a chain transfer agent, there is no particular limitation for the low-molecular weight component and it may be appropriately selected from various kinds of low-molecular weight polymer components. Although there is no particular limitation for weight-average molecular weight of the low-molecular weight component, it is preferably 1,000 to 10,000 and, more preferably, 3,000 to 6,000. When the weight-average molecular weight of the low-molecular weight polymer component is less than 1,000, anti-repulsion property and cohesive force are lowered while, when it is more than 10,000, its compatibility with acrylic polymer as the main component of the pressure-sensitive adhesive composition is lowered whereby anti-repulsion property and cohesive force are lowered.

The weight-average molecular weight of the low-molecular weight polymer component may be controlled by the type and the amount of polymerization initiator and chain transfer agent, temperature and time for the polymerization, concentration of the monomer, dropping speed of the monomer, etc.

In the present invention, the weight-average molecular weight of the low molecular weight polymer was measured under the following measuring conditions.

Name of the apparatus used: "HLC-8120 GPC" manufactured by Tosoh Corporation

Column: "TSK gel Super HZM-H/HZ4000/HZ3000/HZ2000" (manufactured by Tosoh Corporation)

Inlet pressure: 7.2 MPa

Column size: each 6.0 mmφ × 15 cm; 60 cm in total

Column temperature: 40°C

Eluting liquid: tetrahydrofuran (THF)

Flow rate: flowing speed 0.6 mL/min

Sample concentration: 0.1% by weight (a solution in tetrahydrofuran)

Infusing amount of sample: 20 μL

Detector: differential refractometer (RI)

Standard sample: polystyrene (PS)

Data processing apparatus: "GPC-8020" manufactured by Tosoh Corporation

The low-molecular weight polymer component may be used solely or two or more thereof may be used in combination.

The low-molecular weight polymer component is not particularly limited but may be appropriately selected from low-molecular weight polymer components containing various kinds of ethylenically unsaturated monomers as monomer components. As the low-molecular weight polymer component, it is advantageous in view of anti-repulsion property to use an ethylenically unsaturated monomer having a cyclic structure in the molecule thereof (it will be sometime called ''ring-containing ethylenic unsaturated monomer") as a main monomer component.

With regard to a ring in the ring-containing ethylenic unsaturated monomer, any of aromatic ring and non-aromatic ring may be used and non-aromatic ring is preferred. Examples of the aromatic ring include an aromatic hydrocarbon ring (such as a benzene ring and a fused carbon ring such as in naphthalene) and various kinds of aromatic hetero rings. Examples of the non-aromatic ring include a non-aromatic alicyclic ring (a cycloalkane ring such as a cyclopentane ring, a cyclohexane ring, a cycloheptane ring and a cyclooctane ring, a cycloalkene ring such as a cyclohexene ring), and a non-aromatic cross-linked ring (such as a bicyclic hydrocarbon ring in pinane, pinene, bornane, norbornane and norbornene; a tricyclic hydrocarbon ring in adamantine; a cross-linked hydrocarbon ring such as a tetracyclic hydrocarbon ring).

As the ring-containing ethylenically unsaturated monomer, there may advantageously used an ethylenically unsaturated monomer having a cyclic structure in the molecule thereof and having a glass transition temperature (Tg) of from 60 to 190°C when it is formed into a homopolymer (it will be sometimes called "a ring-containing ethylenic unsaturated monomer having Tg of from 60 to 190°C"). Here, the glass transition temperature (Tg) with regard to the ring-containing ethylenic unsaturated monomer having Tg of from 60 to 190°C is a value obtained by the following "Method for measurement of Tg".

(Method for measurement of Tg)

100 parts by weight of a monomer component (i.e., a ring-containing ethylenic unsaturated monomer having Tg of from 60 to 190°C), 0.2 part by weight of azobisisobutyronitrile and 200 parts by weight of ethyl acetate as a polymerization solvent were placed into a reactor equipped with thermometer, stirrer, nitrogen-introducing tube and reflux condenser and stirred for 1 hour together with introduction of nitrogen gas. After oxygen in the polymer system is removed, temperature is raised to 63°C and reaction is carried out for 10 hours. After that, temperature is lowered down to room temperature to give a homopolymer solution in which solid concentration is 33% by weight. After that, the homopolymer solution is applied by casting on a release liner and dried to prepare a test sample (a homopolymer in a sheet form) of about 2 mm thickness. The test sample is punched into a disk of 7.9 mm diameter and sandwiched between parallel plates, viscoelasticity is measured using a viscoelasticity tester (name of the apparatus: "ARES" manufactured by Leometrix) together with applying 1 Hz of shear strain at the temperature range of from -70°C to 150°C at a temperature-rising rate of 5°C/minute under a shearing mode, then a maximum temperature of a loss tangent (tan $\delta$) is determined and the maximum temperature of said loss tangent is defined as a glass transition temperature ($T_g$).

Specific examples of the ring-containing ethylenically unsaturated monomer include non-aromatic ring-containing (meth)acrylate such as cycloalkyl (meth)acrylate (e.g., cyclohexyl (meth)acrylate) and isobornyl (meth)acrylate; aromatic ring-containing (meth)acrylate such as aryl (meth)acrylate (e.g., phenyl (meth)acrylate), aryloxyalkyl (meth) acrylate (e.g., phenoxyethyl (meth)acrylate) and arylalkyl (meth)acrylate (e.g., benzyl (meth)acrylate); and styrene-type monomer such as styrene and $\alpha$-methylstyrene. As the ring-containing ethylenically unsaturated monomer having Tg of from 60 to 190°C, the monomer in which the glass transition temperature is not lower than 60°C (preferably, 60 to 190°C and, more preferably, 63 to 180°C) is appropriately selected from those specifically exemplified hereinabove and is used. Thus, it is possible to use a substance where the glass transition temperature ($T_g$) of a homopolymer formed by the above-mentioned ring-containing ethylenic unsaturated monomer is not lower than 60°C (preferably, 60 to 190°C and, more preferably, 63 to 180°C).

As the ring-containing ethylenically unsaturated monomer (particularly, a ring-containing ethylenically unsaturated monomer having Tg of from 60 to 190°C) in the present invention, a (meth)acrylate having a non-aromatic ring such as cyclohexyl methacrylate and isobornyl (meth)acrylate is preferred and, among them, cyclohexyl methacrylate may be advantageously used.

In the low-molecular weight polymer component, a ring-containing ethylenic unsaturated monomer as a main monomer component may be used solely or two or more thereof may be used in combination.

In the low-molecular weight polymer component, a ring-containing ethylenic unsaturated monomer is used as a main monomer component and, therefore, it is important that its proportion with respect to the total monomer components be 50% by weight or more, preferably 80% by weight or more, more preferably 90% by weight or more and, particularly preferably, 90 to 99% by weight. When the amount of the ring-containing ethylenic unsaturated monomer is less than 50% by weight with respect to the total amount of the monomer components, anti-repulsion property and cohesive force are lowered.

In the low-molecular weight polymer component containing the ring-containing ethylenically unsaturated monomer as a main monomer component, a monomer component (a copolymerizing monomer) capable of being copolymerized with the ring-containing ethylenic unsaturated monomer may be used together according to the necessity. The proportion of such a copolymerizing monomer may be appropriately selected depending upon the type of the monomer component within a range of less than 50% by weight with respect to the total amount of monomer components and, for achieving a good adhesiveness, the use amount is in such an extent that the glass transition temperature of the low-molecular weight polymer component becomes 60°C or higher (preferably, 65 to 180°C). Incidentally, when the glass transition temperature of the low-molecular weight polymer component is lower than 60°C, anti-repulsion property and cohesive force are lowered.

To be more specific, the proportion of the copolymerizing monomer with respect to the total amount of the monomer components is preferably 20% by weight or less, more preferably 10% by weight or less and, particularly preferably 10 to 1% by weight.

Such a copolymerizing monomer may be used solely or two or more thereof may be used in combination.

In the low-molecular weight polymer component, examples of the copolymerizing monomer which may be copolymerized with a ring-containing ethylenically unsaturated monomer in the low-molecular weight polymer component include an alkyl (meth)acrylate such as a $C_{1-20}$ alkyl (meth)acrylate; a carboxyl group-containing monomer such as (meth)acrylic acid and maleic acid or an acid anhydride thereof; a hydroxyl group-containing monomer such as 2-hydroxyethyl (meth)acrylate; an amino group-containing monomer such as N,N-dimethylaminoethyl (meth)acrylate; an epoxy group-containing monomer such as glycidyl (meth)acrylate; a cyano-containing monomer such as acrylonitrile and a methacrylonitrile; a monomer having a nitrogen atom-containing ring such as N-(meth)acryloylmorpholine; a monomer of a vinyl ester type such as vinyl acetate; an olefinic monomer such as ethylene, propylene, isoprene, butadiene and isobutylene; vinyl chloride and vinylidene chloride; an isocyanate group-containing monomer such as 2-(meth) acryloyloxyethyl isocyanate; an alkoxy group-containing monomer such as methoxyethyl (meth)acrylate; a monomer of a vinyl ether type such as methyl vinyl ether and ethyl vinyl ether; and a multifunctional monomer such as 1,6-hexanediol di(meth)acrylate, ethylene glycol di(meth)acrylate, diethylene glycol di(meth)acrylate, triethylene glycol di(meth)acrylate, tetraethylene glycol di(meth)acrylate, (poly)ethylene glycol di(meth)acrylate, propylene glycol di(meth)acrylate, (poly) propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, glycerol di(meth)acrylate, epoxy acrylate, polyester acrylate, urethane acrylate, divinylbenzene, butyl di(meth)acrylate and hexyl di(meth)acrylate.

In the low-molecular weight polymer component, as the copolymerizing monomer which may be copolymerized with a ring-containing ethylenic unsaturated monomer in a low-molecular weight polymer component, a monomer containing a carboxyl group is advantageous and, in view of the heat resistance, acrylic acid may be used particularly advantageously.

Accordingly, as a low-molecular weight polymer component, a low-molecular weight polymer component containing an ethylenically unsaturated monomer having a cyclic structure in the molecule thereof (particularly, cyclohexyl methacrylate) is preferred and a low-molecular weight polymer component containing 90 to 99 parts by weight of cyclohexyl methacrylate and 10 to 1 parts by weight of acrylic acid as monomer components is particularly advantageous.

A low-molecular weight polymer component can be prepared by a conventional or common polymerization method. To be more specific, examples of the method for polymerization of a low-molecular weight polymer component are a solution polymerization method, an emulsion polymerization method, a bulk polymerization method and a polymerization method by irradiation of ultraviolet ray. Incidentally, in polymerization of a low-molecular weight polymer component, it is important to use a chain transfer agent. Further, in polymerization of a low-molecular weight polymer component, appropriate components depending upon each of the polymerization methods such as polymerization initiator, emulsifier and solvent are able to be appropriately selected from conventional or common ones and used.

There is no particular limitation for the amount of the chain transfer agent used therefor but the amount may be appropriately determined depending upon the amount of the low-molecular weight polymer component used and the like. With regard to the amount of the low-molecular weight polymer component, it may be from 5 to 45 parts by weight, preferably, 10 to 40 parts by weight and, and more preferably, 20 to 40 parts by weight, converted as solid, with respect to 100 parts by weight of the acrylic polymer in the pressure-sensitive adhesive composition, like the amount of the tackifier resin having chain transfer property. When the amount of the low-molecular weight polymer component is less than 5 parts by weight, an effect of preventing a rise in a matter which is insoluble in a solvent after a solder reflow step is lowered while, when it is more than 45 parts by weight, tackiness of the pressure-sensitive adhesive composition lowers to lower adhesiveness or tackiness.

The proportion of the chain transfer agent in the low-molecular weight polymer composition may be appropriately determined depending upon the type, the weight-average molecular weight, etc. of the low-molecular weight polymer component and, for example, it may be appropriately selected from the range of from 1 to 20% by weight (preferably 2 to 15% by weight and, more preferably, 2 to 10% by weight) with respect to the total amount of monomer components in the low-molecular weight polymer component.

As mentioned above, in the present invention, when a tackifier resin having chain transfer property or a low-molecular weight polymer composition containing a chain transfer agent is used as a chain transfer substance, adhesiveness of the pressure-sensitive adhesive layer can be enhanced and a solvent-insoluble fraction of the pressure-sensitive adhesive layer can also be finely retained so that the adhesiveness of the pressure-sensitive adhesive layer can be retained in a good state. As a result, anti-repulsion property is effectively enhanced, which is preferable.

As a chain transfer substance, a tackifier resin having chain transfer property is more preferred among the above in view of its better adhesiveness and anti-repulsion property.

Other components

According to the invention, in addition to the above-mentioned components such as an acrylic polymer, a chain transfer agent and a cross-linking agent (crosslinker), the pressure-sensitive adhesive composition may further optionally contain conventional additives such as aging preventer, filler, coloring agent (pigment, dye, etc.), ultraviolet absorber, antioxidant, adhesion-imparting agent, plasticizer, softener, cross-linking agent, surfactant and antistatic agent within such an extent that characteristics of the present invention are not deteriorated.

As the tackifier resin other than the chain transfer substance, there may be mentioned a conventional tackifier resin which is other than those included in the tackifier resin having chain transfer property described above. For example, there may be mentioned a rosin tackifier resin, a terpene tackifier resin, a hydrocarbon tackifier resin, an epoxy tackifier resin, a polyamide tackifier resin, a elastomeric tackfier resin, a phenolic tackfier resin, a ketone tackfier resin and the like. The tackifier resin may be used solely or two or more thereof may be used in combination. Among those, a tackifier resin produced without using formaldehyde as a material (or a raw material) for the tackifier resin may be properly used, from an aspect of reducing amount of formaldehyde diffusion so as to decrease an amount of total outgas. As such a tackifier resin, there may be mentioned, for example, a rosin tackifier resin, a terpene tackifier resin, a hydrocarbon tackifier resin, an epoxy tackifier resin, a polyamide tackfier resin, a elastomeric tackfier resin, and the like.

When the pressure-sensitive adhesive composition is an aqueous-dispersion type (emulsion type) acrylic adhesive pressure-sensitive composition, it is preferred to add the tackifier resin into the pressure-sensitive adhesive composition as a tackifier resin-containing emulsion. As the tackifier resin-containing emulsion, for example, those as described in JP-A-2006-111818 may be used.

When the pressure-sensitive adhesive composition is a solvent-type acrylic pressure-sensitive adhesive composition, as a solvent, there may be mentioned organic solvents, for example, esters such as ethyl acetate, and n-butyl acetate; aromatic hydrocarbons such as toluene, and benzene; aliphatic hydrocarbons such as n-hexane, and n-heptane; alicyclic hydrocarbons such as cyclohexane, and methylcyclohexane; ketones such as methyl ethyl ketone, and methyl isobutyl ketone, and the like. The solvent may be used solely, or two or more thereof may be used in combination.

Pressure-sensitive adhesive layer

A pressure-sensitive adhesive layer in the double-sided pressure-sensitive adhesive tape or sheet for wiring circuit board according to the present invention is formed by a pressure-sensitive adhesive composition as described above. Such a pressure-sensitive adhesive composition may be prepared by mixing an acrylic polymer, and optionally a chain transfer substance or a composition containing a chain transfer substance (a tackifier resin having chain transfer property as a chain transfer substance, a low-molecular weight polymer composition containing a chain transfer agent as a chain transfer substance, etc.) and various additives.

There is no particular limitation for the method of forming a pressure-sensitive adhesive layer but the method may be appropriately selected from the conventional methods for the formation of a pressure-sensitive adhesive layer. Specific examples of the method for the formation of a pressure-sensitive adhesive layer include a method where a pressure-sensitive adhesive composition is applied on a predetermined surface (such as a substrate surface) whereby the thickness after drying becomes a predetermined thickness and then optionally dried or hardened, and a method where a pressure-sensitive adhesive composition is applied on an appropriate separator (such as a release paper) whereby the thickness after drying becomes a predetermined thickness and then optionally dried or hardened and the resultant pressure-sensitive adhesive layer is transcribed (transferred) onto a predetermined surface (such as a substrate surface). In applying the pressure-sensitive adhesive composition, commonly used applying devices (such as a gravure roll coater, a reverse roll coater, a kiss roll coater, a dip roll coater, a bar coater, a knife coater and a spray coater) may be used.

Although the thickness of a pressure-sensitive adhesive layer (as one layer) is not particularly limited, it may be appropriately selected, for example, from a range of from 5 to 70 $\mu$m, preferably from 10 to 60 $\mu$m, and more preferably, from 15 to 50 $\mu$m. When the thickness of a pressure-sensitive adhesive layer is less than 5 $\mu$m, there is a tendency that no good adhesiveness is achieved while, when it is more than 70 $\mu$m, there are some cases where the product is not suitable for the use as a wiring circuit board. Incidentally, the pressure-sensitive adhesive layer may be in any of a form of single layer or plural layers. Particularly, for a solvent-type pressure-sensitive adhesive, when a thickness of the pressure-sensitive adhesive layer is from 5 to 25$\mu$m, the amount of outgas and toluene diffusion can be reduced.

Double-sided pressure-sensitive adhesive tape or sheet for wiring circuit board

The double-sided pressure-sensitive adhesive tape or sheet for wiring circuit board at least has a pressure-sensitive adhesive layer formed by the pressure-sensitive adhesive composition described above. Although the double-sided pressure-sensitive adhesive tape or sheet for wiring circuit board of the present invention may be a double-sided pressure-sensitive adhesive tape or sheet which has no substrate and has only a pressure-sensitive adhesive layer (a double-sided pressure-sensitive adhesive tape or sheet having no substrate) so long as it has the aforementioned pressure-sensitive adhesive layer, it is preferred that, as shown in Fig. 1, it is a double-sided pressure-sensitive adhesive tape or sheet having such a constitution that pressure-sensitive adhesive layers are formed on both surfaces of a substrate (a double-sided pressure-sensitive adhesive tape or sheet having a substrate).

When the double-sided pressure-sensitive adhesive tape or sheet for wiring circuit board is a double-sided pressure-sensitive adhesive tape or sheet having a substrate, although the aforementioned pressure-sensitive adhesive layer may be formed at least one surface of the substrate, it is preferred that such pressure-sensitive adhesive layers are formed on both surfaces of the substrate as shown in Fig. 1. Incidentally, when the aforementioned pressure-sensitive adhesive layer is formed on only one surface of the substrate, a conventional pressure-sensitive adhesive layer or adhesive layer may be formed on the other surface of the substrate.

In such a double-sided pressure-sensitive adhesive tape or sheet for wiring circuit board, it is preferred that the surface of the pressure-sensitive adhesive layer is protected by a release liner. Incidentally, in the double-sided pressure-sensitive adhesive tape or sheet for wiring circuit board, although each pressure-sensitive adhesive surface is protected by two release liners, it is preferred to be protected in a form of being wound in a roll by one sheet of a release liner where both sides are release surfaces as shown in Fig. 1.

In the present invention, the double-sided pressure-sensitive adhesive tape or sheet for wiring circuit board may be produced in a form of being wound in a roll or in a form where a plurality of sheets are layered. Thus, the double-sided pressure-sensitive adhesive tape or sheet for wiring circuit board may be in a form of sheet, tape, etc. When the double-sided pressure-sensitive adhesive tape or sheet for wiring circuit board has a form of being wound in a roll, it is usual that it has a form of being wound in a roll so that each pressure-sensitive adhesive surface (surface of the pressure-sensitive adhesive layer) is protected by one or two release liner(s).

The double-sided pressure-sensitive adhesive tape or sheet for wiring circuit board may have other layers (such as an intermediate layer and an undercoated layer) within such an extent that the advantages of the present invention are not deteriorated by them.

(Substrate)

As a substrate, that having a heat resisting property is preferred and it is possible to use an appropriate thin leafy substance, for example, a fibrous substrate such as cloth, nonwoven fabric, felt and net; a paper substrate such as various types of paper, a metal substrate such as metal foil and metal plate; a plastic substrate such as film or sheet of various kinds of resins (e.g., olefin resin, polyester resin, polyvinyl chloride resin, vinyl acetate resin, amide resin, polyimide resin, polyether ether ketone and polyphenylene sulfide); a rubber substrate such as rubber sheet; a foamed product such as foamed sheet, or a proper thin layered product such as a laminate thereof. The substrate may be in a form of single layer or may have a form of plural layers.

In the present invention, in view of heat-resisting property, anchoring property of a pressure-sensitive adhesive, cost, etc., a fibrous substrate is preferred as a substrate and nonwoven fabric may be particularly preferably used. With regard to a nonwoven fabric, that by natural fiber having a heat-resisting property may be used advantageously and a nonwoven fabric containing Manila hemp may be used particularly advantageously. Even within a preferred range of gel fraction in the present invention, there is a tendency that a processing property lowers due to blocking of a pressure-sensitive adhesive (re-adhesion) in a region where gel fraction is low, but, when the above-mentioned nonwoven fabric is used as a substrate, a processing property becomes good and is hence preferred.

Thickness of the substrate may be appropriately determined depending upon the use and, in general, it is, for example, within 5 to 40 $\mu$m (preferably 10 to 30 $\mu$m and, more preferably, 10 to 20 $\mu$m).

When the substrate is nonwoven fabric, although there is no particular limitation for the basis weight of the nonwoven fabric, it is preferably 5 to 15 g/m$^2$ and, particularly preferably, 6 to 10 g/m$^2$. When the basis weight of nonwoven fabric is less than 5 g/m$^2$, the strength lowers while, when it is more than 15 g/m$^2$, it is difficult to fulfill the required thickness.

With regard to the strength of the substrate, that in an MD direction (longitudinal direction or machine direction) is preferably 2 (N/15 mm) or more and, more preferably, 5 (N/15 mm) or more.

If necessary, surface of the substrate may be applied with an oxidation treatment by a chemical or physical method such as by means of common surface treatment such as treatment with chromic acid, exposure to ozone, exposure to flame, exposure to high-voltage electric shock and treatment with ionizing radiant ray for enhancing the close adhesion to the pressure-sensitive adhesive layer. A coating treatment by an undercoating agent may be applied as well.

(Release liner)

With regard to a release liner (separator), a commonly used release paper or the like may be used. A release liner is used as a protector for a pressure-sensitive adhesive and is peeled off when the double-sided pressure-sensitive adhesive tape or sheet for wiring circuit board is adhered to a wiring circuit board and the like. Incidentally, it is not always necessary to employ the release liner.

Examples of the release liner which may be used include a base material having a release-treating layer such as plastic or paper which is subjected to a surface treatment with a release-treating agent of a silicone type, a long-chain alkyl type, a fluorine type, a molybdenum sulfide type, etc.; a lowly adhesive base material comprising a fluorine-type polymer such as polytetrafluoroethylene, polychlorotrifluoroethylene, polyvinyl fluoride, polyvinylidene fluoride, a copolymer of tetrafluoroethylene with hexafluoropropylene and a copolymer of chlorofluoroethylene with vinylidene fluoride; and a lowly adhesive base material comprising a nonpolar polymer such as an olefin-type resin (such as polyethylene and polypropylene).

The release liner may be formed by a conventional or common method.

There is no particular limitation for thickness of the release liner as well.

The double-sided pressure-sensitive adhesive tape or sheet for wiring circuit board according to the present invention can be prepared utilizing the above-exemplified method for the formation of a pressure-sensitive adhesive layer in such a manner that a pressure-sensitive adhesive layer is formed on each side of the substrate optionally through other layer in the case of a double-sided pressure-sensitive adhesive tape or sheet having a substrate, or in such a manner that a pressure-sensitive adhesive layer is formed on a release liner optionally through other layer in the case of a double-sided pressure-sensitive adhesive tape or sheet having no substrate.

According to the present invention, in the double-sided pressure-sensitive adhesive tape or sheet for wiring circuit board, thickness from one pressure-sensitive adhesive surface to the other pressure-sensitive adhesive surface is preferably 20 to 70 $\mu$m, more preferably 20 to 60 $\mu$m and, particularly preferably, 30 to 60 $\mu$m. When the thickness from one pressure-sensitive adhesive surface to the other pressure-sensitive adhesive surface is less than 20 $\mu$m in the double-sided pressure-sensitive adhesive tape or sheet for wiring circuit board, there are some cases where good adhesiveness or adhesiveness is not achieved while, when it is more than 70 $\mu$m, the thickness is too large whereby it is not generally suitable as a double-sided pressure-sensitive adhesive tape or sheet for wiring circuit board.

Since the double-sided pressure-sensitive adhesive tape or sheet for wiring circuit board of the present invention has a good adhesiveness, it is appropriately used for fixing a wiring circuit board to a supporting body such as a reinforcing plate and the like. Furthermore, since the double-sided pressure-sensitive adhesive tape or sheet for wiring circuit board of the present invention has a small generation amount of total outgas and a small diffusion amount of toluene, it is excellent in environmental properties. Particularly, the double-sided pressure-sensitive adhesive tape or sheet for wiring circuit board of the present invention is preferable since it is safe when used in applications which may affect a human body due to gas generation, such as an application for automobiles. Further, by adjusting the gel fraction of the pressure-sensitive adhesive layer in the initial stage and difference in gel fractions as described above, a good adhesiveness is provided, an excellent anti-repulsion property can be exerted even when subjected to a high-temperature step such as a solder reflow step, and an effect of suppressing or preventing the self-adhesion of the cut sides after a cutting process is improved.

Wiring circuit board

The wiring circuit board of the present invention has at least an electric insulator layer (may be sometimes called "base insulating layer") and an electric conductor layer (may be sometimes called "conductor layer") formed on the above-mentioned base insulating layer to form a predetermined circuit pattern and, on the back side (i.e., a side of the base insulating layer opposite to the conductor layer side) of the wiring circuit board, the above-mentioned double-sided pressure-sensitive adhesive tape or sheet for wiring circuit board is adhered. Accordingly, the wiring circuit board of the present invention can be, for example, fixed to a support such as a reinforcing plate utilizing the double-sided pressure-sensitive adhesive tape or sheet for wiring circuit board adhered on the back side thereof.

In the present invention, the wiring circuit board may optionally have an electric insulator layer for covering (may be sometimes called "cover insulation layer") and the like disposed on the above-mentioned conductor layer, in addition to a base insulating layer and a conductor layer formed on the base insulating layer so as to form a predetermined circuit pattern.

The wiring circuit board may have a multi-layered structure where plural wiring circuit boards are layered. With regard to the numbers of the wiring circuit board (layer numbers of the multiple layers) in the wiring circuit board having a multi-layered structure, there is no particular limitation provided that the numbers are 2 or more.

With regard to the wiring circuit board of the present invention, although there is no particular limitation so long as it is a wiring circuit board, a flexible printing wiring circuit board (FPC) is advantageous. The wiring circuit board of the present invention may be advantageously used as a wiring circuit board to be used in various kinds of electronic instruments.

(Base insulating layer)

A base insulating layer is an electric insulator layer formed by an electric insulating material. As the electric insulating material for forming the base insulating layer, there is no particular limitation and it can be appropriately selected from known electric insulating materials employed in wiring circuit board and used. Specific examples of the electric insulating material include a plastic material such as polyimide resin, acrylate resin, polyether nitrile resin, polyether sulfone resin, polyester resin (such as polyethylene terephthalate resin and polyethylene naphthalate resin), polyvinyl chloride resin, polyphenylene sulfide resin, polyether ketone resin, polyamide resin (such as the so-called "aramid resin"), polyallylate resin, polycarbonate resin and liquid crystal polymer; a ceramic material such as alumina, zirconia, soda glass and quartz glass; and various kinds of composite materials having electric insulating property (nonconductive property). Each of electric insulating material may be used solely or two or more thereof may be used in combination.

As the electric insulating material in the present invention, a plastic material (particularly a polyimide resin) is advantageous. Accordingly, a base insulating layer is preferred to be formed by a plastic film or sheet (particularly, film or sheet which is prepared by a polyimide resin).

As the electric insulating material, an electric insulating material having photosensitivity (e.g., a photosensitive plastic material such as photosensitive polyimide resin) may also be used.

A base insulating layer may be in any form of a single layer or a layered product. Surface of the base insulating layer may be subjected to various kinds of surface treatment (such as corona discharge treatment, plasma treatment, surface-roughening treatment and hydrolyzing treatment).

Although there is no particular limitation for thickness of the base insulating layer, it may be appropriately selected within the range of, for example, 3 to 100 $\mu$m (preferably 5 to 50 $\mu$m and, more preferably, 10 to 30 $\mu$m).

(Conductor layer)

A conductor layer is an electric conductor layer formed by an electrically conductive material. The conductor layer is formed on the above-mentioned base insulating layer so as to form a predetermined circuit pattern. As the electrically conductor material for the formation of such a conductor layer, there is no particular limitation and appropriate one may be selected from the conventional electrically conductive materials used for wiring circuit boards for use. Specific examples of the electrically conductive material include various kinds of alloy (such as solder), metal material such as platinum and an electrically conductive plastic material in addition to copper, nickel, gold and chromium. Each electrically conductive material may be used solely or two or more thereof may be used in combination. In the present invention, a metal material (particularly copper) is suitable as an electrically conductive material.

A conductor layer may be in any form of a single layer or a layered product. Surface of the conductor layer may be subjected to various kinds of surface treatment.

Although there is no particular limitation for thickness of the conductor layer, it may be appropriately selected within, for example, a range of 1 to 50 $\mu$m (preferably 2 to 30 $\mu$m and, more preferably, 3 to 20 $\mu$m).

With regard to a method for the formation of a conductor layer, there is no particular limitation but it may be appropriately selected from known methods for the formation thereof (known patterning method such as a subtractive method, an additive method and a semi-additive method). When, for example, a conductor layer is directly formed on the surface of a base insulating layer, a conductor layer can be formed by plating or vapor deposition of a conductor material on a base insulating layer utilizing a non-electrolytic plating method, an electrolytic plating method, a vacuum vapor deposition method, a sputtering method, and the like so as to give a predetermined circuit pattern.

(Cover insulating layer)

A cover insulating layer is an electric insulator layer for covering (electric insulator layer for protection) which is formed by an electric insulating material and covers the conductor layer. A cover insulating layer is disposed according to the necessity and is not necessary to be disposed at all times. As the electrically insulating material for the formation of a cover insulating layer, there is no particular limitation but, the same as in the case of a base insulating layer, it may be appropriately selected from conventional electrically insulating materials used for wiring circuit boards for use. To be more specific, As the electrically insulating material for the formation of a cover insulating layer, examples thereof include the electrically insulating material which are exemplified as an electrically insulating material for the formation of the above base insulating layer and, the same as in the case of a base insulating layer, a plastic material (particularly a polyimide resin) is advantageous. Each electrically insulating material for the formation of a cover insulating layer may be used solely or two or more thereof may be used in combination.

A cover insulating layer may be in any form of a single layer or a layered product. Surface of the cover insulating layer may be subjected to various kinds of surface treatment (such as corona discharge treatment, plasma treatment, treatment for making the surface rough and hydrolyzing treatment).

With regard to thickness of a cover insulating layer, there is no particular limitation but it may be appropriately selected within, for example, a range of 3 to 100 $\mu$m (preferably 5 to 50 $\mu$m and, more preferably, 10 to 30 $\mu$m).

With regard to a method for the formation of a cover insulating layer, there is no particular limitation but it may be appropriately selected from known methods for the formation thereof (such as a method where a liquid substance or a melted substance containing an electrically insulating material is applied followed by drying, and a method where film or sheet which corresponds to the shape of the conductor layer and is formed from an electrically insulating material is layered).

Reinforcing plate

The wiring circuit board of the present invention may, for example, be used by being fixed to a support such as a reinforcing plate. Such a reinforcing plate is usually disposed on the side of the base insulting layer opposite to the conductor layer side (back side). With regard to the reinforcing material for the formation of the reinforcing plate, there is no particular limitation but it may be appropriately selected from known reinforcing plate materials for the formation of reinforcing plate and is used. The reinforcing plate material may be that having electric conductivity or that having no electric conductivity. To be more specific, examples of the reinforcing plate material include a metal material such as stainless steel, aluminum, copper, iron, gold, silver, nickel, titanium and chromium; a plastic material such as polyimide resin, acrylate resin, polyether nitrile resin, polyether sulfone resin, polyester resin (such as polyethylene terephthalate resin and polyethylene naphthalate resin), polyvinyl chloride resin, polyphenylene sulfide resin, polyether ether ketone resin, polyamide resin (such as the so-called "aramid resin"), polyallylate resin, polycarbonate resin, epoxy resin, glass epoxy resin and liquid polymer; and an inorganic material such as alumina, zirconia, soda glass, quartz glass and carbon. Each reinforcing material may be used solely or two or more thereof may be sued in combination.

As the reinforcing plate material, a metal plate such as stainless steel and aluminum and a plastic material such as polyimide resin are advantageous and, among them, stainless steel and aluminum can be used especially advantageously. Accordingly, it is preferable that the reinforcing plate is formed by metal foil or metal plate (such as stainless steel foil or plate and aluminum foil or plate) or a plastic film or sheet (such as film or sheet made of polyimide resin).

A reinforcing plate may be in any form of a single layer or a layered product. Surface of the reinforcing plate may be subjected to various kinds of surface treatment.

With regard to thickness of a reinforcing plate, there is no particular limitation but it may be appropriately selected within, for example, a range of 50 to 2,000 $\mu$m (preferably 100 to 1,000 $\mu$m).

Examples

The present invention will now be more particularly illustrated by way of the following Examples. However, the present invention is not limited thereto.

EXAMPLE 1

In a reaction vessel equipped with a condenser, a nitrogen-flowing tube, a thermometer and an agitator, 0.279g of 2,2'-azobis[N-(2-carboxyethyl)-2-methylpropionamidine] hydrate (a polymerization initiator, trade name: "VA-057", produced by Wako Pure Chemical Industries, Ltd.) and 100 g of ion-exchanged water were introduced and stirred for l hour with flowing nitrogen gas therein.

This was maintained at 60°C, and, thereto, 400g of an emulsion (an emulsion of monomer raw material) prepared by adding 29 parts by weight of butylacrylate, 67 parts by weight of 2-ethylhexylacrylate, 4 parts by weight of acrylic acid, 0.02 parts by weight of 3-methacryloyloxypropyltrimethoxy silane (trade name: "KBM-503", produced by Shin-Etsu Chemical Co., Ltd.), 0.033 parts by weight of dedecanediol (laurylmercaptane, as a chain transfer agent), and 2 parts by weight of sodium polyoxyethylenelaurylsulfate (an emulsifying agent) into 41 parts by weight of ion-exchanged water for emulsification, was dropwisely added slowly over 3 hours for carrying out an emulsion polymerization. After the addition of the emulsion of the monomer raw material finished, it was further maintained and aged at the same temperature for 3 hours. A 10% ammonia water was added thereto to adjust the solution property to pH 7.5. As such, an aqueous-dispersion type acrylic polymer solution (an acrylic polymer emulsion) was obtained.

To this acrylic polymer emulsion, a tackifier resin emulsion (an aqueous-dispersion type emulsion of a polymer rosin resin having a softening point of 160°C, trade name: "Super Ester E-865NT", produced by Arakawa Chemical Industries, Ltd.) was added in a proportion of 20 parts by weight (converted as solid) per 100 parts by weight of solid of the acrylic polymer contained in the emulsion, to obtain a pressure-sensitive adhesive composition (an aqueous-dispersion type acrylic pressure-sensitive adhesive composition).

Separately, a release treatment layer comprising a silicone-type release treatment agent was formed on the surface of a glassine paper to prepare a release liner. The pressure-sensitive adhesive composition was applied on the surface of the release liner (the surface of the release treatment layer) and dried at 100°C for 2 minutes to form a pressure-sensitive adhesive layer having 22 $\mu$m thickness. After that, nonwoven fabric of Manila hemp (thickness: 18 $\mu$m) was laminated on the pressure-sensitive adhesive layer, then the pressure-sensitive adhesive composition was applied onto the surface of the nonwoven fabric, followed by drying at 100°C for 2 minutes to form another pressure-sensitive adhesive layer whereby a double-sided pressure-sensitive adhesive tape or sheet where the total thickness (thickness from the surface of one pressure-sensitive adhesive layer to the surface of the other pressure-sensitive adhesive layer) was 50 $\mu$m was prepared (the pressure-sensitive adhesive layer was dipped in a part of the nonwoven fabric).

EXAMPLE 2

In 210 parts by weight of ethyl acetate, 90 parts by weight of 2-ethylhexyl acrylate and 10 parts by weight of acrylic acid were subjected to a solution polymerization treatment by stirring at 60 to 80°C in the presence of 0.4 part by weight of 2, 2'-azobisisobutyronitrile under substitution with nitrogen, to prepare an acrylic polymer solution (viscosity: about 120 poises; degree of polymerization: 99.2%; solid: 30.0% by weight).
With respect to 100 parts by weight (solid) of this acrylic polymer solution, 20 parts by weight ofterephenol resin (a tackifier resin having chain transfer property, trade name: "YS POLYSTER S145", softening point: 145°C, produced by YASUHARA CHEMICAL CO.,LTD.), 0.05 parts by weight of a multifunctional epoxy-type cross linking agent (trade name: TETRAD-C, produced by MITSUBISHI GAS CHEMICAL COMPANY, INC.), and 1 part by weight of an anti-aging agent (trade name: "Irganox 1010", produced by Ciba Specialty Chemicals, LTD.), each converted as solid, were added and mixed to obtain a pressure-sensitive adhesive composition.

Separately, a release treatment layer comprising a silicone-type release treatment agent was formed on the surface of a glassine paper to prepare a release liner. The pressure-sensitive adhesive composition was applied on the surface of the release liner (the surface of the release treatment layer) and dried at 130°C for 5 minutes to form a pressure-sensitive adhesive layer having 22 $\mu$m thickness. After that, nonwoven fabric of Manila hemp (thickness: 18 $\mu$m) was laminated on the pressure-sensitive adhesive layer, then the pressure-sensitive adhesive composition was applied onto the surface of the nonwoven fabric, followed by drying at 130°C for 5 minutes to form another pressure-sensitive adhesive layer whereby a double-sided pressure-sensitive adhesive tape or sheet where the total thickness (thickness from the surface of one pressure-sensitive adhesive layer to the surface of the other pressure-sensitive adhesive layer) was 50 $\mu$m was prepared (the pressure-sensitive adhesive layer was dipped in a part of the nonwoven fabric).

COMPARATIVE EXAMPLE 1

In 210 parts by weight of ethyl acetate, 90 parts by weight of 2-ethylhexyl acrylate and 10 parts by weight of acrylic acid were subjected to a solution polymerization treatment by stirring at 60 to 80°C in the presence of 0.4 part by weight of 2,2'-azobisisobutyronitrile under substitution with nitrogen, to prepare an acrylic polymer solution (viscosity: about 120 poises; degree of polymerization: 99.2%; solid: 30.0% by weight).

To this acrylic polymer solution, 2 parts by weight of aromatic isocyanate-type cross linking agent (trade name: "CORONATE L", produced by NIPPON POLYURETHANE INDUSTRY CO., LTD.), converted as solid, with respect to 100 parts by weight (solid) of the above acrylic polymer solution was added and mixed to obtain a pressure-sensitive adhesive composition.

The pressure-sensitive adhesive composition was applied on the surface of the release liner which is the same as in Example 1, and then dried at 130°C for 5 minutes to form a pressure-sensitive adhesive layer having a total thickness of 50 $\mu$m to obtain a double-sided pressure-sensitive adhesive tape or sheet having no substrate.

Evaluation

Evaluation methods used in the present invention will be explained below. Gel fractions of the pressure-sensitive adhesive layer before and after the heat treatment and difference between them (gel fraction in the initial stage, gel fraction after reflow step and difference in gel fractions), adhesive force, anti-repulsion property, processing property, an amount of total outgas and a diffusion amount of toluene for the double-sided pressure-sensitive adhesive tapes or sheets prepared in Examples 1 and 2 and Comparative Example 1 were measured or evaluated by the following measuring method or evaluation method. Results of the measurement or the evaluation are shown in Table 1.

As mentioned above, the gel fraction after a reflow step (after heat treatment) is a gel fraction after a solder flow step satisfying the following heat treatment conditions and difference in gel fraction is the difference between the gel fraction (% by weight) after the solder reflow step and the gel fraction (% by weight) in the initial stage.

(Heat treatment conditions in a solder reflow step)

(1) The surface temperature of the double-sided pressure-sensitive adhesive tape or sheet reaches 175 $\pm$ 10°C within 130 to 180 seconds after start of the solder reflow step for the double-sided pressure-sensitive adhesive tape or sheet.

(2) The surface temperature of the double-sided pressure-sensitive adhesive tape or sheet reaches 230 ± 10°C within 200 to 250 seconds after start of the solder reflow step for the double-sided pressure-sensitive adhesive tape or sheet.

(3) The surface temperature of the double-sided pressure-sensitive adhesive tape or sheet reaches 255 ± 15°C within 260 to 300 seconds after start of the solder reflow step for the double-sided pressure-sensitive adhesive tape or sheet.

(4) The solder reflow step finishes within 370 seconds after start of the solder reflow step for the double-sided pressure-sensitive adhesive tape or sheet.

Surface temperature of the double-sided pressure-sensitive adhesive tape or sheet (or pressure-sensitive adhesive layer) in the solder reflow step was measured continuously via a temperature sensor after fixing a thermocouple on the surface of the double-sided pressure-sensitive adhesive tape or sheet (or pressure-sensitive adhesive layer) by using a pressure-sensitive adhesive tape (heat-resistant pressure-sensitive adhesive tape having a polyimide film as a substrate). At that time, the solder reflow instrument used in the solder reflow step and the temperature sensor used in the measurement of the surface temperature are as follows.
Solder reflow instrument: Conveyer-type far-infrared hot wind heating device (manufactured by Noritake Co., Ltd.)
Temperature sensor: Keyence NR-250 (Keyence Corporation)

(1) Gel fractions before and after heat treatment and the difference between them

Each of the pressure-sensitive adhesive compositions for the formation of a pressure-sensitive adhesive layer in each double-sided pressure-sensitive adhesive tape or sheet was applied onto a release liner and then dried or hardened to form a pressure-sensitive adhesive layer (may be sometimes called "pressure-sensitive adhesive layer in the initial stage").
Further, a pressure-sensitive adhesive layer which was formed in the same manner as above was set in a solder reflow instrument or device which was set for fulfilling the above-mentioned heat treatment conditions [highest temperature or peak temperature is set at 260°C; conveyer-type far-infrared hot wind heating device (manufactured by Noritake Co., Ltd.)] and then subjected to a heat treatment (the resulting pressure-sensitive adhesive layer after the heat treatment may be sometimes called "pressure-sensitive adhesive layer after heating"). Surface temperature of the pressure-sensitive adhesive layer was continuously measured with a temperature sensor [Keyence NR-250 (manufactured by Keyence Corporation)] after fixing a thermocouple on the surface of the pressure-sensitive adhesive layer by using a pressure-sensitive adhesive tape (heat-resistant pressure-sensitive adhesive tape having a polyimide film as a substrate).
Each of the pressure-sensitive adhesive layers (the pressure-sensitive adhesive layer of initial the stage and the pressure-sensitive adhesive layer after heating) was detached from a release liner in a size of 5 cm × 5 cm, wrapped with a tetrafluoroethylene sheet containing pores having an average pore diameter of 0.2 μm (trade name: "NTF 1122" manufactured by Nitto Denko Corporation) and tied with kite string and the weight at that time was measured and defined as the weight before dipping. Incidentally, the weight before dipping is the total weight of the pressure-sensitive adhesive layer, the tetrafluoroethylene sheet and the kite string. Further, the total weight of the tetrafluoroethylene sheet and the kite string was also measured and the weight was defined as a package weight.
After that, the product where the pressure-sensitive adhesive layer (pressure-sensitive adhesive layer in the initial stage or pressure-sensitive adhesive layer after heating) was wrapped with the tetrafluoroethylene sheet followed by being tied up with the kite string was placed in a 50-ml container filled with ethyl acetate and allowed to stand at room temperature for one week (7 days). Then, the tetrafluoroethylene sheet was taken out from the container, transferred to a cup made of aluminum and dried in a drier at 130°C for 2 hours to remove ethyl acetate, then the weight of the sample was measured and the weight was defined as a weight after dipping.
Gel fraction is then calculated by the following formula.

$$\text{Gel fraction (\% by weigh)} = (A - B)/(C - B) \times 100 \qquad (1)$$

(In the formula (1), A is the weight after dipping, B is a package weight and C is the weight before dipping).
Difference between the gel fractions before and after the heat treatment (gel fraction difference) is calculated by the following formula from the gel fraction (% by weight) of the pressure-sensitive adhesive layer in the initial stage and the gel fraction (% by weight) of the pressure-sensitive adhesive layer after heat treatment.

$$\text{Gel fraction difference (points)} = E - D \qquad (2)$$

(In the formula (2), D is the gel fraction (% by weight) of the pressure-sensitive adhesive layer in the initial stage and E is the gel fraction (% by weight) of the pressure-sensitive adhesive layer after heat treatment).

(2) Adhesive force

After each of the double-sided pressure-sensitive adhesive tapes or sheets was cut into a size of 20 mm in width and 100 mm in length, a polyester film (thickness: 25 $\mu$m) was adhered on one pressure-sensitive adhesive surface, then another surface was adhered to a polished plate made of stainless steel by a method including one reciprocation of a roller of 2 kg (width of 50 mm), aging was conducted for 30 minutes under the conditions with a temperature of 23°C and a relative humidity of 65%, and it was then peeled off under the conditions with a temperature of 23°C and a relative humidity of 65% using a tensile tester at 180°C peeling angle and at a peeling rate of 300 mm/minute, whereby a 180° peel strength (N/20 mm) was measured.

(3) Anti-repulsion property

One of the pressure-sensitive adhesive surfaces of each double-sided pressure-sensitive adhesive tape or sheet was adhered to a model FPC (having a characteristic as shown in Table 2) as a lining material using a hand roller under the condition with a temperature of 23°C, then bonded with pressure at 0.4 MPa at about 60°C using a laminator and cut into a size of 50 mm length and 10 mm width to prepare a sample for evaluation of anti-repulsion property in the initial stage (i.e., a sample before subjected to a solder reflow step).

Further, one of the pressure-sensitive adhesive surfaces of each double-sided pressure-sensitive adhesive tape or sheet was adhered to a model FPC (having a characteristic as shown in Table 2) as a lining material using a hand roller under the condition with a temperature of 23°C, then bonded with the pressure of 0.4 MPa at about 60°C using a laminator, subjected to a solder reflow step satifying the above-mentioned heat treatment conditions (highest temperature or peak temperature is set at 260°C) and cut into a size of 50 mm length and 10 mm width to prepare a sample for evaluation of anti-repulsion property after a reflow step (after heat treatment).

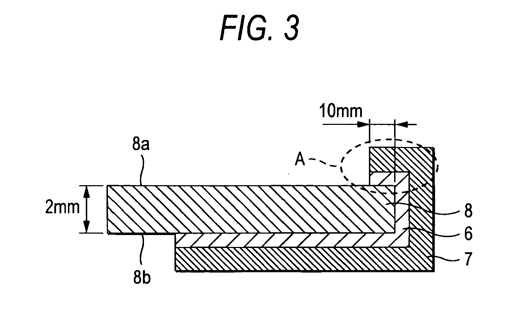

Each of the samples for evaluation of anti-repulsion property prepared as such was adhered to the surface of a polyimide plate in an adherend [a layered plate of a polyimide plate (trade name: "Kapton 300H" manufactured by DuPont; thickness: 75 $\mu$m) with an aluminum plate; total thickness: 2 mm] using a roller (one reciprocal movement) of 2 kg (width of 50 mm) under the condition with a temperature of 23°C to the site of one of the ends so as to make the adhered area 10 mm $\times$ 10 mm followed by being allowed to stand for 30 minutes. After each sample for evaluation of anti-repulsion property was allowed to stand for 30 minutes, it was folded and fixed by adhering on the surface of the aluminum plate in the adherend with a roller of 2 kg (one reciprocal movement) as shown in Fig. 3. After the fixing, each sample for evaluation of anti-repulsion property was placed in a drier set at 60°C for 72 hours, then the floating state of the sample on the polyimide plate side was observed and an anti-repulsion property was evaluated according to the following evaluating criteria. Tested numbers for each of the samples for evaluation of anti-repulsion property (sample for evaluation of anti-repulsion property in the initial stage and sample for evaluation of anti-repulsion property after reflow step) are made 3.

Evaluating criteria

Good: no floating was observed at all

Poor: floating was observed

Fig. 3 is a rough cross-sectional view showing the adhered state of the double-sided pressure-sensitive adhesive tape or sheet for evaluating the anti-repulsion property in a method for evaluation of anti-repulsion property. In Fig. 3, 6 is a double-sided pressure-sensitive adhesive tape or sheet, 7 is a lining material (a model FPC having the characteristic as shown in Table 2), 8 is an adherend (a layer plate comprising polyimide plate and aluminum plate), 8a is the surface of the polyimide plate side and 8b is the surface of the aluminum plate side. The area surrounded by a dashed line in A is an area where floating is checked.

(4) Processing property

A release liner where a release treating layer comprising a silicone-type release treating agent had been formed on the surface of synthetic paper was adhered onto the pressure-sensitive adhesive surface exposed on each of the double-sided pressure-sensitive adhesive tape or sheet prepared in Examples 1 and 2 and Comparative Example 1 to prepare a double-sided pressure-sensitive adhesive tape or sheet of a double separator type. The resulting double-sided pressure-sensitive adhesive tape or sheet of a double separator type was subjected to a half cutting using a pressing machine from the side of a release liner which had been already adhered from the initial stage (a release liner where a release treating layer comprising a silicone-type release treatment agent had been formed on the surface of a glassine paper) to prepare a sample for evaluation of a processing property. The sample for evaluation of a processing property was allowed to stand for one week under the atmosphere of temperature of 60°C and relative humidity of 90%, the resulting state whether a self-adhesion of the cut surfaces was observed and a processing property was evaluated according to the following evaluating criteria.

Evaluating criteria for processing property

Good: no self-adhesion was noted on the cut surfaces

Poor: self-adhesion was noted on the cut surfaces

(5) Diffusion amount of toluene

A sample of a predetermined size (1 cm $\times$ 5 cm, area of 5 cm$^2$) was cut from the double-sided pressure-sensitive adhesive tapes or sheets obtained in Examples 1 and 2 and Comparative Example 1, the release liner was peeled off, and then the sample was adhered on aluminum foil to prepare a test sample (one surface was adhered to aluminum foil, and the other surface was exposed as a pressure-sensitive adhesive surface).

The test sample was put into a vial (21.5 ml content) and sealed. After that, the vial containing the test sample was heated at 80°C by head space auto sampler for 30 minutes, and 1.0 ml gas of the heating state was injected into a gas chromatography measuring instrument (GC measuring instrument) and the measurement was carried out.

An amount of toluene was measured, and the toluene content ($\mu$g/g) per unit weight of the test sample (the double-sided pressure-sensitive adhesive tape or sheet) was calculated and quantified (from the toluene content in the heated gas of 1 ml, an amount of toluene in a volume of 21.5 ml was calculated, and this was converted into a value per unit weight of the test sample).

The measurement conditions of the gas chromatography are as follows:

(Measurement conditions of head space auto sampler)

Instrument: Hewlett Packard 7694

Pressure-applying time: 0.12 minutes

Loop-charging time: 0.12 minutes

Loop-equilibrium time: 0.05 minutes

Injection time: 3.0 minutes

Sample loop temperature: 160°C

Transfer line temperature: 200°C

(Measurement conditions of gas chromatography)

Instrument: Hewlett Packard 6890

Column: DB-FFAP 1.0 $\mu$m (0.535 mm$\phi$ $\times$ 30 m)

Carrier gas: He 5.0 mL/min (constant flow mode)

Column head pressure: 24.3 kPa (40°C)

Injection head: split (split ratio of 12:1, temperature of 250°C)

Column temperature: 40°C (0 minute) - <+10°C /min> $\rightarrow$ 90°C (0 minute) - <+20°C /min> $\rightarrow$ 250°C (2 minutes)

(Namely, the temperature was raised from 40°C to 90°C at temperature raising rate of 10°C /min, was subsequently raised to 250°C at temperature raising rate of 20°C/min, and was then maintained at 250°C for 2 minutes.) Detector: FID (temperature of 250°C)

(6) Amount of total outgas

The same measurement as in the above (5) was carried out, and an amount of total outgas was converted by toluene reference and calculated as a generating amount per unit weight of the test sample.

Table 1

| | Amount of total outgas ($\mu$g/g) | Amount of toluene diffusion ($\mu$g/g | Adhesive Force (N/20mm) | Gel Fraction (wt %) | | | Anti-repulsion property | | Processing Property |
|---|---|---|---|---|---|---|---|---|---|
| | | | | Initial Stage (% by weight) | After Heating (% by weight) | Gel Fraction Difference (point) | Initial Stage | After Heating | |
| Ex. 1 | 30 | 1.5 | 9 | 53.0 | 49.1 | -3.9 | Good | Good | Good |
| Ex. 2 | 98 | 5 | 15 | 58.4 | 56.3 | -2.1 | Good | Good | Good |
| Comp. Ex.1 | 2,900 | 1,800 | 8 | 68.2 | 95.2 | 27.0 | Poor | Poor | Poor |

Table 2 (Characteristic of Model FPC)

| | Cu | PI | Cu | Thickness | Reaction Force (10 mm x 10 mm) |
|---|---|---|---|---|---|
| Double-Sided FPC | 1 oz | 1 mil | 1 oz | 180 $\mu$m | about 300 g |

From Table 1, it has been confirmed that the double-sided pressure-sensitive adhesive tape or sheet according to each of the Examples 1 and 2 has a small generating amount of VOC as well as excellent punching processing property and anti-repulsion property and thus can be advantageously used as a double-sided pressure-sensitive adhesive tape or sheet to be used for wiring circuit board.

While the present invention has been described in detail and with reference to specific embodiments thereof, it will be apparent to one skilled in the art that various changes and modifications can be made therein without departing from the scope thereof.

This application is based on Japanese patent application No. 2007-264234 filed on October 10, 2007, the entire contents thereof being hereby incorporated by reference.

Further, all references cited herein are incorporated in their entireties.

**Claims**

1. A double-sided pressure-sensitive adhesive tape or sheet for use in wiring circuit board, which comprises a pressure-sensitive adhesive layer formed by a pressure-sensitive adhesive composition containing an acrylic polymer as a main component,

    said double-sided pressure-sensitive adhesive tape or sheet having an amount of total outgas of 250 $\mu$g/g or less and a diffusion amount of toluene of 10 $\mu$g/g or less.

2. A double-sided pressure-sensitive adhesive tape or sheet for use in wiring circuit board, which comprises a substrate, a first pressure-sensitive adhesive layer provided on one surface of the substrate, and a second pressure-sensitive adhesive layer provided on the other surface of the substrate, wherein at least one of the first and second pressure-sensitive adhesive layers is formed by a pressure-sensitive adhesive composition containing an acrylic polymer as a main component,

    said double-sided pressure-sensitive adhesive tape or sheet having an amount of total outgas of 250 $\mu$g/g or less and a diffusion amount of toluene of 10 $\mu$g/g or less.

3. The double-sided pressure-sensitive adhesive tape or sheet according to claim 1 or 2, wherein the pressure-sensitive adhesive layer has a gel fraction in the initial stage of 40 to 70% by weight, and a difference between a gel fraction (% by weight) after a solder reflow step and the gel fraction (% by weight) in the initial stage is 10 or less, said solder reflow step satisfying the following heat treatment conditions:

    (1) a surface temperature of said pressure-sensitive adhesive tape or sheet reaches 175 $\pm$ 10°C within 130 to 180 seconds after start of the solder reflow step for said pressure-sensitive adhesive tape or sheet;

(2) the surface temperature of said pressure-sensitive adhesive tape or sheet reaches 230 ± 10°C within 200 to 250 seconds after start of the solder reflow step for said pressure-sensitive adhesive tape or sheet;
(3) the surface temperature of said pressure-sensitive adhesive tape or sheet reaches 255 ± 15°C within 260 to 300 seconds after start of the solder reflow step for said pressure-sensitive adhesive tape or sheet; and
(4) the solder reflow step finishes within 370 seconds after start of the solder reflow step for said pressure-sensitive adhesive tape or sheet.

4. The double-sided pressure-sensitive adhesive tape or sheet according to claim 1 or 2, wherein the pressure-sensitive adhesive composition further contains a chain transfer substance.

5. The double-sided pressure-sensitive adhesive tape or sheet according to claim 4, wherein the chain transfer substance is at least one of a compound having a hydroxyl group and a compound having a thiol group.

6. The double-sided pressure-sensitive adhesive tape or sheet according to claim 4, wherein the chain transfer substance is a tackifier resin containing a phenolic hydroxyl group, or a chain transfer agent

7. The double-sided pressure-sensitive adhesive tape or sheet according to claim 6, wherein the tackfier resin containing a phenolic hydroxyl group is at least one member selected from the group consisting of a phenol-modified terpene tackifier resin, a phenol-modified rosin tackifier resin and a phenolic tackifier resin.

8. The double-sided pressure-sensitive adhesive tape or sheet according to claim 6, wherein the pressure-sensitive adhesive composition contains a low-molecular weight polymer composition comprising a low-molecular weight polymer component and a chain transfer agent for adjusting the molecular weight of the low-molecular weight polymer component, whereby the chain transfer agent is contained in the pressure-sensitive adhesive composition.

9. The double-sided pressure-sensitive adhesive tape or sheet according to claim 8, wherein the low-molecular weight polymer component contains, as a main monomer component, an ethylenically unsaturated monomer having a cyclic structure in the molecule thereof.

10. The double-sided pressure-sensitive adhesive tape or sheet according to claim 9, wherein the low-molecular weight polymer component contains, as monomer components, 90 to 99 parts by weight of cyclohexyl methacrylate and 10 to 1 part by weight of acrylic acid.

11. The double-sided pressure-sensitive adhesive tape or sheet according to claim 6, wherein the pressure-sensitive adhesive composition contains, as the chain transfer substance, the tackifier resin containing a phenolic hydroxyl group in a proportion of 5 to 45 parts by weight with respect to 100 parts by weight of the acrylic polymer.

12. The double-sided pressure-sensitive adhesive tape or sheet according to claim 8, wherein the pressure-sensitive adhesive composition contains the low-molecular weight polymer composition containing the chain transfer agent as the chain transfer substance so that the low-molecular weight polymer component is contained in a proportion of 5 to 45 parts by weight with respect to 100 parts by weight of the acrylic polymer.

13. The double-sided pressure-sensitive adhesive tape or sheet according to claim 2, wherein the substrate comprises nonwoven fabric.

14. The double-sided pressure-sensitive adhesive tape or sheet according to claim 1, wherein the pressure-sensitive adhesive layer has a thickness of 5 to 70 μm.

15. The double-sided pressure-sensitive adhesive tape or sheet according to claim 2, wherein the first and second pressure-sensitive adhesive layers each have a thickness of 5 to 70 μm.

16. The double-sided pressure-sensitive adhesive tape or sheet according to claim 1 or 2, which has a thickness from one pressure-sensitive adhesive surface to the other pressure-sensitive adhesive surface of 20 to 70 μm.

17. A wiring circuit board comprising an electric insulator layer and an electric conductor layer provided on the electric insulator layer so as to form a predetermined circuit pattern, wherein the double-sided pressure-sensitive adhesive tape or sheet according to claim 1 or 2 is adhered on the back side of the wiring circuit board.

## FIG. 1

# FIG. 2

IR REFLOW TEMPERATURE PROFILE

Legend:
- — — PEAK AT 250 DEG. C
- —— PEAK AT 260 DEG. C
- - - - PEAK AT 270 DEG. C

Y-axis: TEMPERATURE [DEG. C]
X-axis: TIME [SEC.]

# FIG. 3

**Europäisches Patentamt**
**European Patent Office**
**Office européen des brevets**

## EUROPEAN SEARCH REPORT

Application Number

EP 08 01 7743

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 234 865 A (TESA AG [DE]) 28 August 2002 (2002-08-28) | 1-17 | INV. C09J7/02 |
| Y | * abstract * * paragraphs [0016] - [0018], [0021], [0027], [0032], [0036] - [0038], [0054]; claims; examples 4,3,9; table 2 * | 1-17 | C09J7/04 |
| X | EP 1 234 864 A (TESA AG [DE]) 28 August 2002 (2002-08-28) | 1-17 | |
| Y | * abstract * * paragraphs [0011], [0014] - [0027], [0034], [0039] - [0044], [0057]; claims; examples 1-3; table 1 * | 1-17 | |
| X | DE 102 34 246 A1 (TESA AG [DE]) 5 February 2004 (2004-02-05) * paragraphs [0076], [0087] - [0089]; claims; examples 1-3; table 4 * | 1-17 | |
| P,X | EP 1 845 145 A (NITTO DENKO CORP [JP]) 17 October 2007 (2007-10-17) | 1-17 | TECHNICAL FIELDS SEARCHED (IPC) |
| P,Y | * abstract * * paragraphs [0010], [0036] - [0050], [0082], [0090] - [0106]; claims; examples 1-4 * | 1-17 | C09J |
| A | US 2003/077442 A1 (INOKUCHI SHINJI [JP] ET AL) 24 April 2003 (2003-04-24) * paragraph [0013]; claim 1 * | 1-17 | |

The present search report has been drawn up for all claims

| Place of search | Date of completion of the search | Examiner |
|---|---|---|
| Munich | 13 January 2009 | Meier, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 08 01 7743

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2009

| Patent document cited in search report | | Publication date | Patent family member(s) | | Publication date |
|---|---|---|---|---|---|
| EP 1234865 | A | 28-08-2002 | DE | 10109066 A1 | 12-09-2002 |
| | | | ES | 2283473 T3 | 01-11-2007 |
| | | | US | 2002168517 A1 | 14-11-2002 |
| EP 1234864 | A | 28-08-2002 | DE | 10109067 A1 | 12-09-2002 |
| | | | JP | 2002309210 A | 23-10-2002 |
| | | | US | 2002161129 A1 | 31-10-2002 |
| DE 10234246 | A1 | 05-02-2004 | AU | 2003242748 A1 | 25-02-2004 |
| | | | WO | 2004015020 A1 | 19-02-2004 |
| | | | EP | 1529087 A1 | 11-05-2005 |
| | | | JP | 2005533918 T | 10-11-2005 |
| | | | US | 2006057372 A1 | 16-03-2006 |
| EP 1845145 | A | 17-10-2007 | JP | 2007302868 A | 22-11-2007 |
| | | | KR | 20070101144 A | 16-10-2007 |
| | | | US | 2007237949 A1 | 11-10-2007 |
| US 2003077442 | A1 | 24-04-2003 | CN | 1414053 A | 30-04-2003 |
| | | | JP | 3901490 B2 | 04-04-2007 |
| | | | JP | 2003127299 A | 08-05-2003 |
| | | | SG | 123538 A1 | 26-07-2006 |

EPO FORM P0459

For more details about this annex : see Official Journal of the European Patent Office, No. 12/82

**EP 2 048 210 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001040301 A
- JP 2006111818 A
- JP 2007264234 A